# EUROPEAN PATENT SPECIFICATION

(11) **EP 4 432 570 B1**
(45) Date of publication and mention of the grant of the patent: **02.12.2026**
(21) Application number: 24163185.2
(22) Date of filing: 13.03.2024
(51) Int. Cl.: H04B 3/56

(54) **CIRCUIT STRUCTURE TO IMPROVE RELIABILITY OF POWER LINE COMMUNICATION**
SCHALTUNGSSTRUKTUR ZUR VERBESSERUNG DER ZUVERLÄSSIGKEIT VON STROMLEITUNGSKOMMUNIKATION
STRUCTURE DE CIRCUIT POUR AMÉLIORER LA FIABILITÉ D'UNE COMMUNICATION PAR LIGNE ÉLECTRIQUE

(30) Priority: 15.03.2023 TW 112109611; 08.05.2023 TW 112117026; 06.06.2023 TW 112121141
(43) Date of publication of application: 18.09.2024
(73) Proprietor: Hangzhou Lianxintong Semiconductor Co., Ltd., Hangzhou City Zhejiang (CN)
(72) Inventor: LI, HSIN-HSIEN, 302 Zhubei City (TW)
(74) Representative: Lang, Christian

(56) References cited:
- EP-A2- 1 323 246
- EP-A2- 2 416 080
- EP-B1- 1 323 246
- WO-A1-2008/018441
- GB-A- 2 542 577

## Description

### FIELD OF THE INVENTION

This disclosure relates to power line communication (PLC), and more particularly to a device of optimizing power line communication and an operation method thereof. The associated method may also be applied to wired communication applications using twisted pairs or coaxial cables.

### DESCRIPTION OF RELATED ART

The PLC has been widely used in many fields since the end of 1990, for example, HomePlug AV standard, Generation 3rd Power Line Communication (G3-PLC), High Speed PLC (HPLC) and the like. Because the power grid usually has the problems including the high noise and impedance varying with time and the like, the communication quality thereof generally becomes poor. In view of this, this disclosure proposes a new architecture capable of significantly improving the above-mentioned problems.

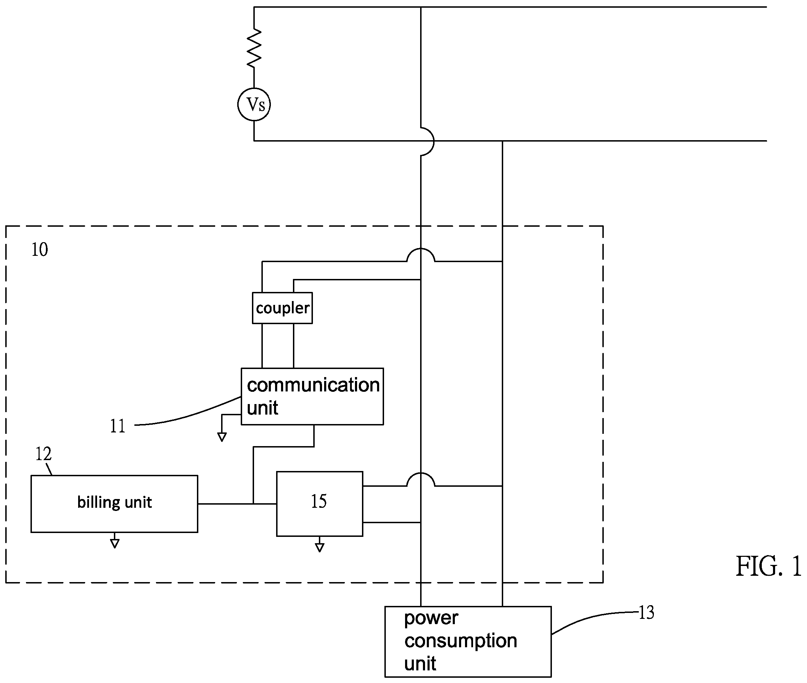

Previously, a low-pass filter or an isolator is utilized in some applications to separate the power line into several sections, so that the influence range of the power consumption apparatus is reduced. However, the power consumption unit and the communication unit are still concurrently present on the isolated power line, and noise and impedance variations generated by the power consumption unit still affect the communication quality of this section of the power line. In addition, FIG. 1 is a schematic view showing a circuit structure 10 of a conventional intelligent electricity meter, wherein a communication unit 11 receives and transmits a power line signal through a coupler, a billing unit 12 calculates and analyzes associated power consumption data according to the power line signal, and a high-voltage alternating current to low-voltage direct current (AC-DC) power supply unit 15 extracts a power energy wave from the power line to provide the electric direct current (DC) power required by the communication unit and a billing unit. Therefore, the noise and impedance variations of a conventional power consumption unit 13 and the conventional AC-DC power supply unit 15 affect the communication quality of the communication unit 11. Several methods have been proposed to address the issues of interference and reliability in power line communication. For example, EP 1 323 246 A2 discloses a power line networking apparatus including an interference filter and a coupling circuit for suppressing electromagnetic interference and transmitting data signals. WO 2008/018441 A1 discloses a power supply device with an impedance adjuster between the power connector and an AC/DC converter. GB 2 542 577 A discloses a building management system utilizing PLC, with filters at the input of lighting power circuits and series inductors in the load circuit.

### SUMMARY OF THE INVENTION

The invention is defined by the subject-matter of the independent claims. This disclosure discloses a circuit structure to improve reliability of power line communication and to significantly improve the communication quality of the power line. Because the power line functions as the necessary path for powering the terminal power consumption apparatus on the power grid, the communication signal may also be transmitted using the frequency band much higher than the power supply frequency (DC or 50/60 Hz). Generally speaking, however, the conventional power line communication (PLC) has two big problems causing the poor communication quality. First, the noise generated by the power consumption apparatus, including the modem itself, enters the power line, so that the power line is full of the time-varying noise, and the stable and reliable communication quality cannot be obtained. Second, the impedance on the power line also changes with time as the power consumption mode of the power consumption facility changes. In addition, once the heavy load (low impedance) state is present, the transmission signal transmitted onto the power line is highly attenuated, and it is difficult to transmit the transmission signal for a longer distance.

The concept of this disclosure is to dispose a low-pass filter or an isolator in front of the power consumption unit, including a modem itself. The low-pass 3dB frequency turning point of this filter is much lower than the communication signal, so that the communication signal can be isolated without affecting the power supply and the power line can be separated into two sections, one of which is a transmission terminal, and the other of which is a power consumption terminal. The communication signal of the modem (communication unit) at the transmission terminal bypasses this filter through a coupler, and enters the transmission terminal of the power line. Consequently, with regard to the frequency band used by the communication signal of the communication unit, the time-varying noise and the time-varying impedance are isolated at the power consumption terminal, and the transmission terminal becomes the transmission medium with the stable impedance and the low noise, so that the communication effect can be significantly improved. In addition, if the power supply apparatus on the power grid is disposed at the terminal where the communication frequency band generates the noise or the low impedance is present, similar filters also need to be added at the exit and the entrance of the power supply apparatus to prevent the communication signal from the interference or from being highly attenuated on the power line.

This disclosure also discloses a circuit structure to improve reliability of power line communication, wherein the circuit structure has a power line, on which a power energy wave and a network signal are transmitted. The circuit structure includes a first isolator and a first coupler. The first isolator is disposed at an entrance of a power consumption terminal of the circuit structure. The first isolator separates the power line into the power consumption terminal and a transmission terminal, and filters the network signal, so that the power energy wave enters the power consumption terminal. The first coupler generates a first coupling path, through which the network signal enters the transmission terminal via the first coupler without passing through the first isolator. Power line impedance at a side of the transmission terminal is not affected by power consumption at a side of the power consumption terminal.

### BRIEF DESCRIPTION OF DRAWINGS

FIG. 1 shows the prior art.
FIGS. 2A and 2B are schematic views showing an embodiment of a circuit structure of this disclosure.
FIGS. 3A to 3I are schematic views showing an isolator 201 or 14.
FIG. 4A is a schematic view showing the circuit structure of this disclosure used in a household indoor power grid 400A.
FIG. 4B is a schematic view showing the circuit structure of this disclosure used in an outdoor power grid 400B.
FIG. 5 is a schematic view showing the circuit structure of this disclosure used in a vehicle power grid 500.

### DETAILED DESCRIPTION OF THE INVENTION

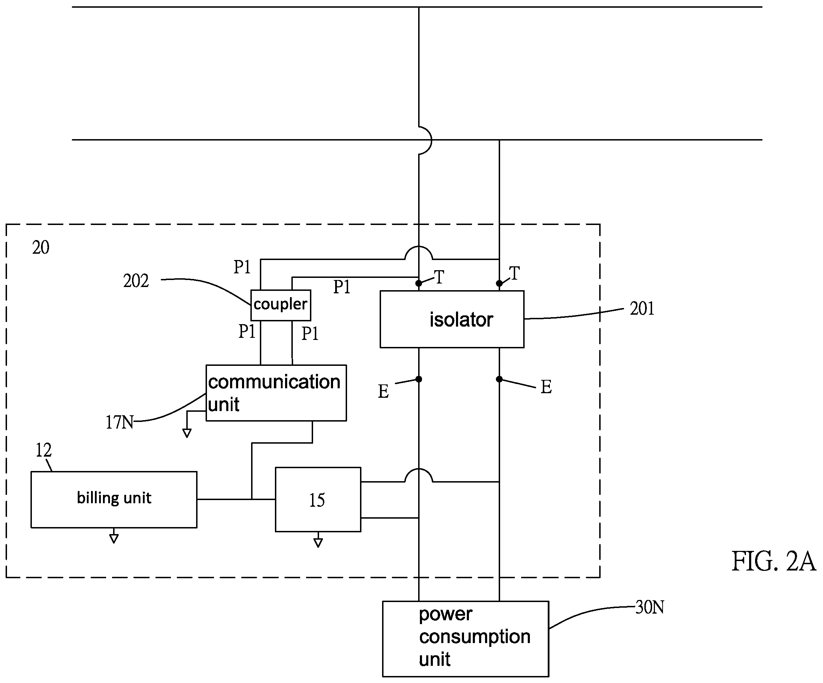

FIG. 2A is a schematic view showing a circuit structure of this disclosure used in an electricity meter 20. Referring to FIG. 2A, with regard to the low-voltage power supply networks mostly disposed on the current intelligent grids, the electricity meter 20 is the entrance of each electricity user. If the electricity meter is improved, then the success rate of communication of the low-voltage power supply network can be effectively improved. The electricity meter 20 of this disclosure includes an isolator 201, a billing unit 12, a coupler 202, a communication unit 17N and a high-voltage alternating current to low-voltage direct current (AC-DC) power supply unit 15. The billing unit 12 calculates and analyzes associated power consumption data according to a power line signal. The high-voltage alternating current to low-voltage direct current (AC-DC) power supply unit 15 coupled to a power consumption terminal extracts a power energy wave of the power consumption terminal to provide electric DC power required by the billing unit 12 and the communication unit 17N of the transmission terminal. Please note that a communication signal of the communication unit 17N bypasses the isolator 201 through a coupling path P1 via the coupler 202, so that the communication signal enters the communication unit 17N on the power line.

The electricity meter 20 of one embodiment includes one billing unit 12. The billing unit 12 is disposed between a first isolator 201 and a power consumption unit 30N, and performs billing according to the power energy wave generated after the first isolator 201 filters the network signal.

In one embodiment, the billing unit 12 is coupled to the communication unit 17N, and data of the billing unit 12 of the electricity meter 20 can be uploaded to the cloud through the communication unit. The objective thereof is to manage the energy usage and billing more effectively. The electricity meter 20 can transmit data, including messages of electricity consumption, power consumption time, load peaks and the like, to a cloud data center (power station) in a real-time manner using the Internet technology and cloud calculation.

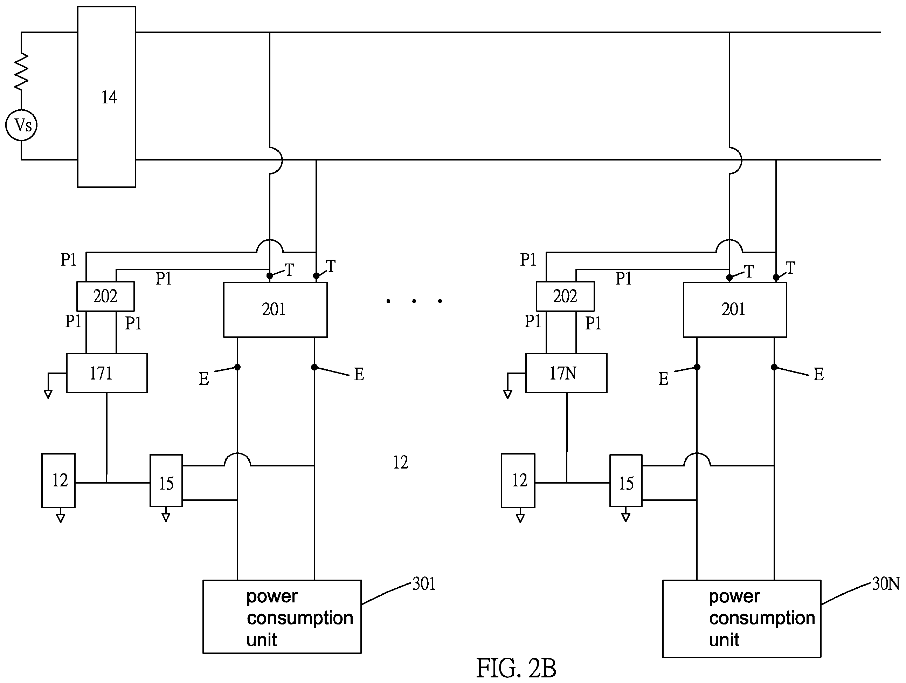

FIG. 2B is a schematic view showing the isolator 201 and the coupler 202 in one embodiment of this disclosure. Referring to FIGS. 2A and 2B, an isolator 14 is an isolator close to the power terminal, and is implemented by a low frequency low-pass filter or an active isolator. The network signal is transmitted to entrances of communication units 171 to 17N (or transmission terminal T) through the coupling path P1, but cannot enter a side of a power consumption terminal E (or the power consumption terminal E side) through the isolator 201, while the low-frequency power energy wave can pass through the isolator 201 and then enter the side of the power consumption terminal E, and the power energy wave provides energy to power consumption units 301 to 30N. In this embodiment, the isolator 201 may be implemented by a low frequency low-pass filter or an active isolator.

The new architecture proposed in this disclosure is to dispose an additional low-pass filter (the active isolator may also be regarded as a low-pass filter) at an entrance of each or some of the power consumption units (e.g., 30N) of the power line communication (PLC) device. The 3dB cut-off frequency of the filter falls at the very low frequency (see FIGS. 2A and 2B) with respect to the communication signal. In one embodiment, the cut-off frequency of the isolator 201 is lower than the transmission frequency of the network signal, and higher than a frequency of the power energy wave. So, only a very little proportion of the noise generated by the power consumption unit 30N can enter the frequency band of the communication signal through the isolator 201, and the communication signal itself needs to bypass the isolator 201 through the coupling path P1 and enter the communication unit 17N. In other words, time-varying noise and impedance generated by the power consumption unit 30N cannot affect the communication.

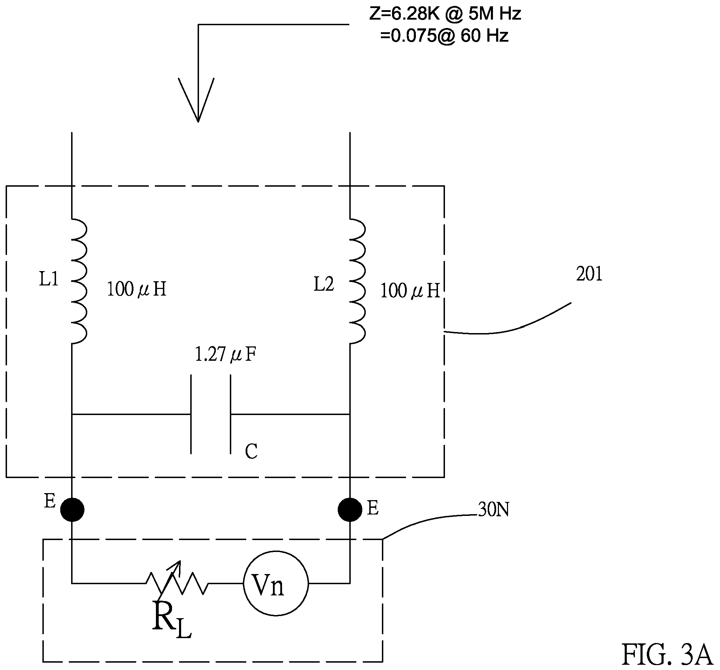

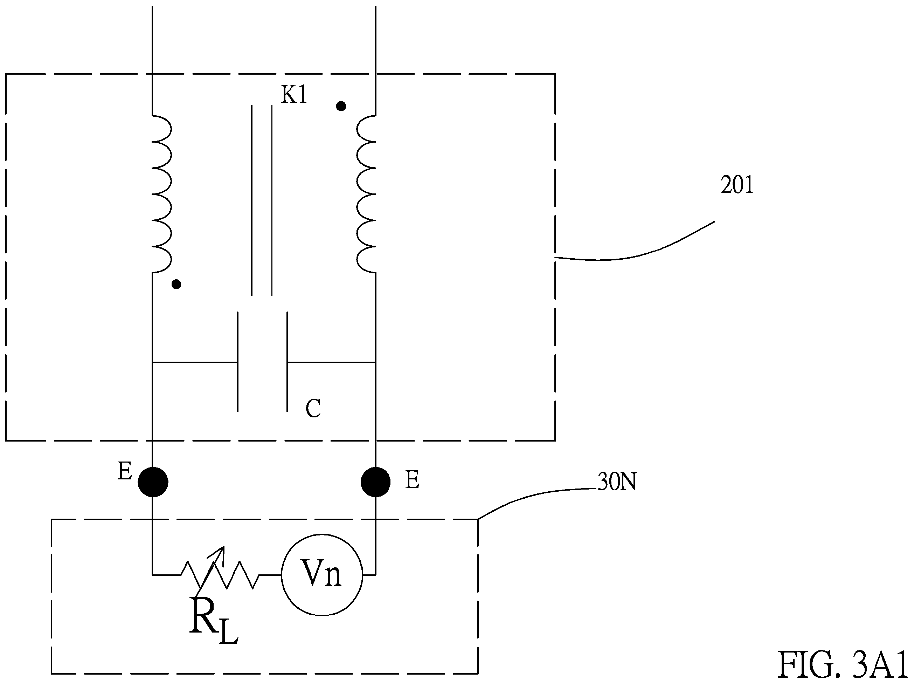

This architecture has another advantage to be described in the following. The isolator 201 is configured to be a circuit serially connected to the high impedance in the communication frequency band with respect to the transceiver. So, the communication signal transmitted from the transceiver to the power line cannot be easily attenuated, and the time-varying degree is low, so that the stable and good communication quality can be held. FIG. 3A shows an embodiment of the isolator 201 being a low frequency low-pass filter. Referring concurrently to FIG. 3A, the isolator 201 in this embodiment includes two inductors L1 and L2, and a capacitor C, wherein the power line is serially connected to the inductors L1 and L2, and parallelly connected to the capacitor C.

Please note that the inductors L1 and L2 are disposed at the entrance of the input terminal of the isolator 201. In other words, the inductors L1 and L2 are disposed on an outer side of the capacitor C. That is, the capacitor C is disposed between the inductor L1 or L2 and the power consumption unit 30N. Consequently, when the angular frequency is equal to ω, the impedance of the power consumption terminal E facing the signal outputted from the transmission terminal T approaches ωL1+ωL2, and the value of which is almost kept unchanged. In other words, the power line impedance at the side of the transmission terminal T (or the transmission terminal T side) cannot change with the change of the power consumption behavior at the side of the power consumption terminal E. So, the side of the transmission terminal T becomes a stable transmission medium, and the attenuation amount of the communication signal at the side of the transmission terminal T is not affected by the power consumption behavior of the power consumption terminal E.

It is assumed that the inductance values of the inductors L1 and L2 are equal to 100 µH and the capacitance is equal to 1.27 µF. If the frequency of the alternating current (AC) signal is equal to 60 Hz, then the inductor of the low-pass filter (isolator 201) has the impedance equivalent to 0.075 ohms and does not affect the usage of the normal electric power. If the network signal falls at about 5 MHz, then the impedance facing the network signal is equal to about 6,280 ohms, and the network signal is not affected by the impedance R_{L} of the power consumption unit 30N. Meanwhile, only a little proportion of the noise's equivalent voltage Vn generated by the power consumption unit 30N can pass through the low frequency low-pass filter (isolator 201) and affect the network signal. If there is a power unit present on the power line, then the low frequency low-pass filter (isolator 14) is generally needed at the power output terminal to improve the transmission line (or cable) impedance (see FIG. 2B).

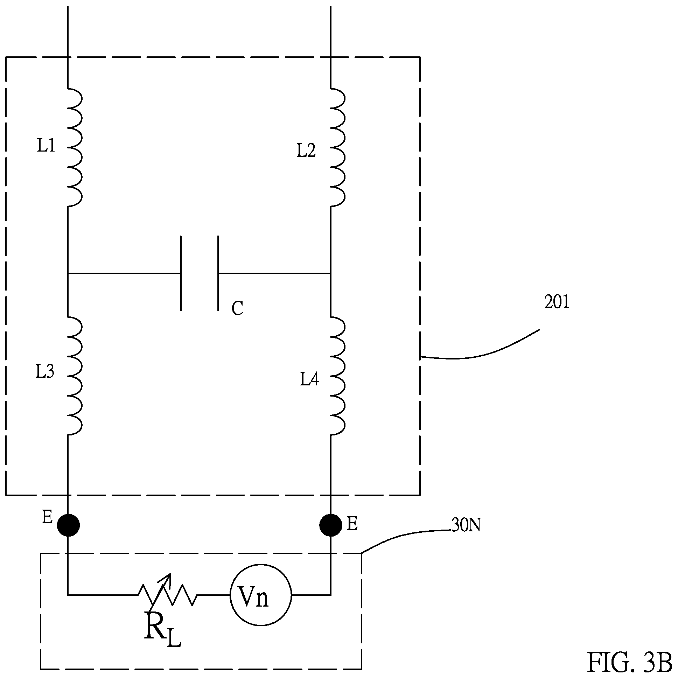

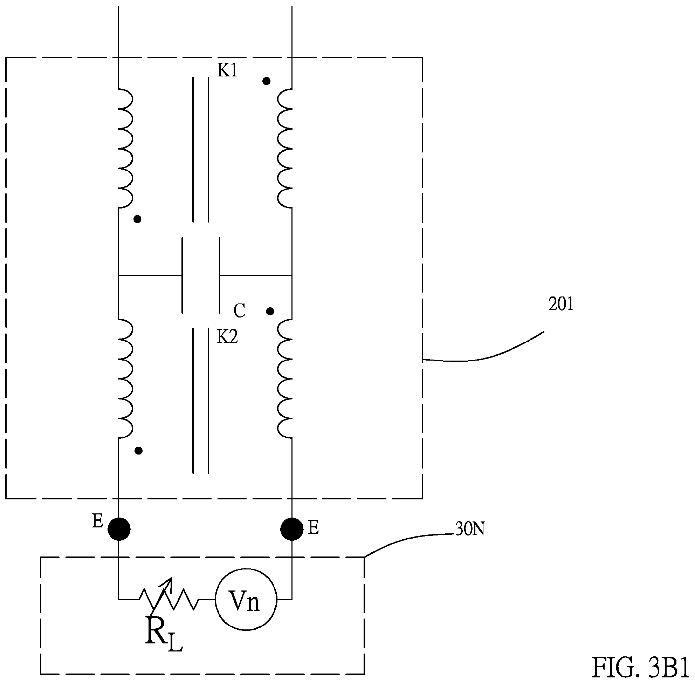

FIG. 3B shows another embodiment, in which the isolator 201 is the low frequency low-pass filter. Referring to FIG. 3B, the isolator 201 in this embodiment includes four inductors L1, L2, L3 and L4, and a capacitor C. The inductors L1 and L3 are serially connected to the power line, and the inductors L2 and L4 are serially connected to the power line. The inductors L1 and L2 are disposed on an outer side of the capacitor C. The capacitor C is parallelly connected to the power line, and disposed between the inductors L1 and L2 and the power consumption unit 30N, wherein the other principles are the same as those mentioned hereinabove. If the noise source energy at the power consumption side is very strong and the internal resistance at the power consumption side is lower, then the low frequency low-pass filter of FIG. 3B or even the more advanced low frequency low-pass filter has the better isolation effect.

Please note that the isolator may be implemented by a low-pass filter, and the advantage is that the design becomes easy. However, the application scene, such as an electricity meter, having the high current needs the large-size and high-cost inductor and the high-voltage capacitor also having the similar problem. So, a lower-cost solution is to adopt a reversely connected transformer to replace the inductor, as shown in FIGS. 3A1 and 3B1. FIGS. 3A1 and 3B1 are schematic views respectively showing isolators in one embodiment. In FIG. 3A1, the transformer K1 is serially connected to the power line, and a capacitor is parallelly connected to the power line. The transformer K1 is disposed at an entrance of an input terminal of the isolator 201, or the transformer K1 is disposed on an outer side of the capacitor C, so that the power energy wave firstly passes through the transformer K1 and is then transmitted to the power consumption terminal E. In FIG. 3B1, the transformers K1 and K2 are respectively serially connected to the power line, and the capacitor C is parallelly connected between the power line and the transformers K1 and K2. The transformers K1 and K2 are disposed at an entrance of an input terminal of the isolator 201, or the transformer K1 is disposed on an outer side of the capacitor C, so that the power energy wave firstly passes through the transformers K1 and K2 and is then transmitted to the power consumption terminal E.

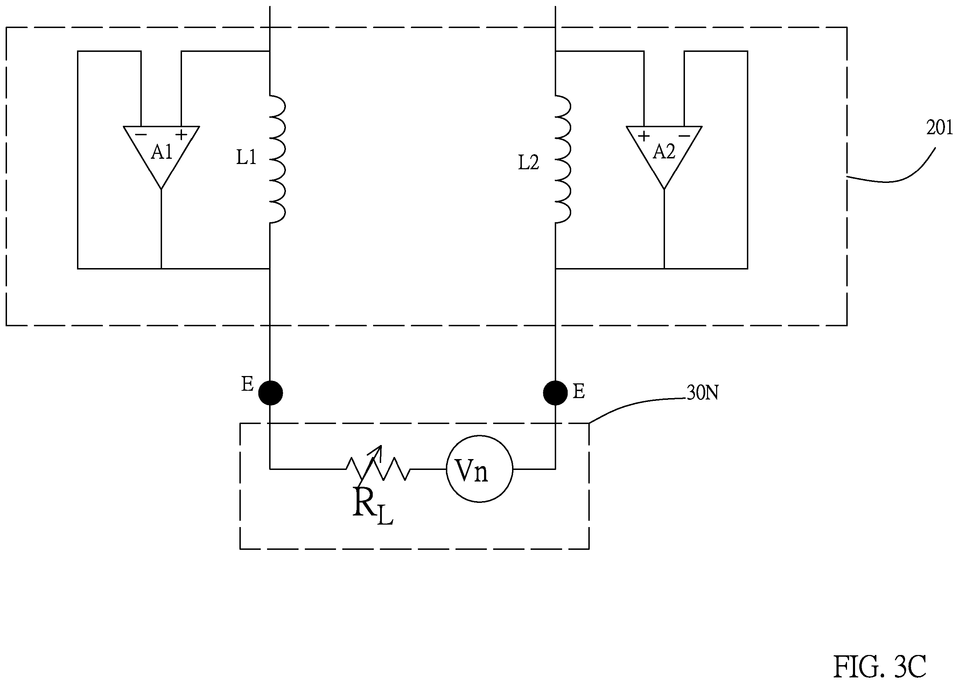

Another approach of dramatically improving the isolation effect uses an active isolator to reduce the requirement on the transformer or the inductance value, as shown in FIGS. 3C to 3I. FIG. 3C shows a basic concept of an active isolator, wherein each isolator 201 includes inductors L1 and L2 and amplifiers A1 and A2. The inductors L1 and L2 are respectively serially connected to the power line. The amplifiers A1 and A2 are respectively coupled to two sides of the inductors L1 and L2. The noninverting input terminals of the amplifiers A1 and A2 are respectively coupled to starting terminals of the inductors L1 and L2, output terminals of the amplifiers A1 and A2 are respectively coupled to the inverting input terminals of the amplifiers A1 and A2 and ending terminals of the inductors L1 and L2, and the noninverting input terminals of the amplifiers A1 and A2 are coupled to the starting terminals of the inductors L1 and L2. The inductors L1 and L2 can detect the potential change in the communication frequency band through the higher current at the low frequency. The voltage difference between two sides of the inductor can be reduced to (1/A) times through the amplifiers A1 and A2 having the gain (A), and the equivalent impedance of the isolator 201 can be increased to (A) times, so that the desired effect can be obtained using the very small inductor. In one embodiment, each of the amplifiers A1 and A2 is implemented by a voltage follower. In addition, the low impedance is seen at the lower sides of the inductors L1 and L2 (i.e., the power consumption terminal E side), and the noise current generated by the power consumption side can be absorbed to achieve effects of isolating the noise and holding the high impedance at the upper sides of the inductors L1 and L2 (i.e., the transmission terminal T side).

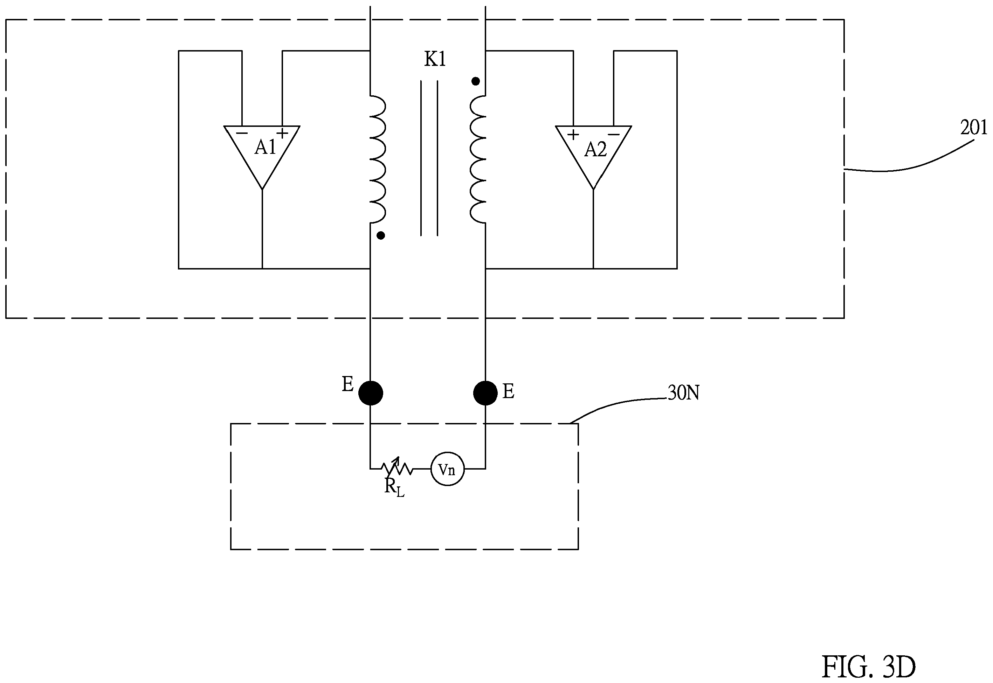

In FIG. 3D, the inductor is replaced with the transformer K1 because the core is shared, and the cost thereof may be further decreased. In addition, because the actual impedance of the reverse mutual induction can be higher than that of the simple induction, the isolator of this embodiment includes: a transformer K1 serially connected to the power line; and two amplifiers A1 and A2 respectively coupled to the starting terminal of the primary-side coil and the starting terminal of the secondary-side coil of the transformer K1. The output terminals of the amplifiers A1 and A2 are respectively coupled to the inverting input terminals of the amplifiers A1 and A2, and the ending terminal of the primary-side coil or the ending terminal of the secondary-side coil of the transformer K1. The noninverting input terminals of the amplifiers A1 and A2 are respectively coupled to the starting terminal of the primary-side coil and the starting terminal of the secondary-side coil of the transformer K1.

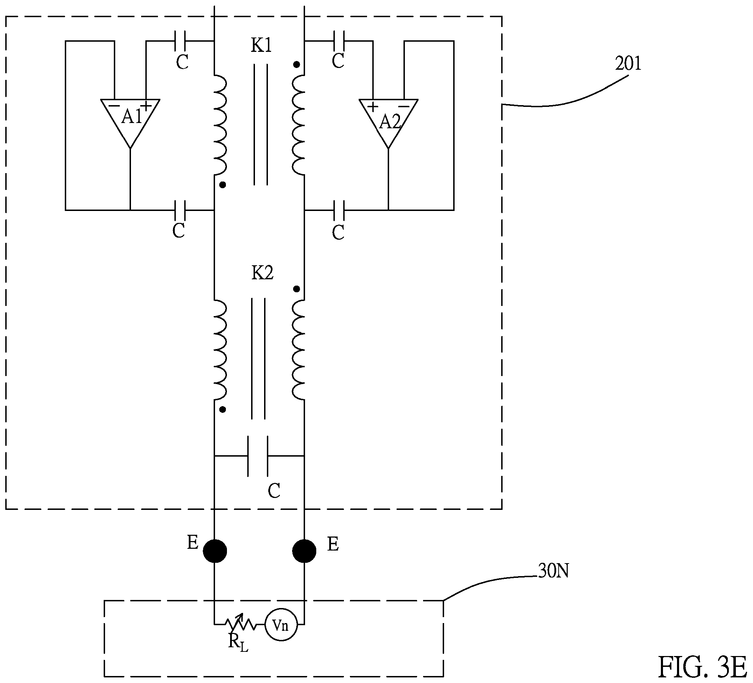

In actual use, another transformer K2 or a low-pass filter may be placed between the output terminals of the amplifiers A1 and A2 and the side of the power consumption terminal E to reduce the specification requirements on the maximum current outputs of the amplifiers A1 and A2, as shown in FIG. 3E. The isolator of this embodiment includes: two transformers K1 and K2 respectively serially connected to the power line; and two amplifiers A1 and A2 respectively coupled to the starting terminal of the primary-side coil and the starting terminal of the secondary-side coil of the transformer K1. The output terminals of the amplifiers A1 and A2 are respectively coupled between the inverting input terminals of the amplifiers A1 and A2, and the two transformers K1 and K2. The noninverting input terminals of the amplifiers A1 and A2 are respectively coupled to the starting terminal of the primary-side coil and the starting terminal of the secondary-side coil of the transformer K1. Because it is used in an electricity meter, the power line at the high-voltage side is parallelly connected to a high-voltage capacitor C. That is, the high-voltage capacitor C is parallelly connected between the ending terminal of the primary-side coil and the ending terminal of the secondary-side coil of the transformer K2 and the power line, and parallelly connected between the starting terminal of the primary-side coil or the starting terminal of the secondary-side coil of the transformer K1, the noninverting input terminals of the amplifiers A1 and A2 and the power line. Capacitors C are respectively parallelly connected between the ending terminal of the primary-side coil or the ending terminal of the secondary-side coil of the transformer K1, the inverting input terminals and the output terminals of the amplifiers A1 and A2 and the power line.

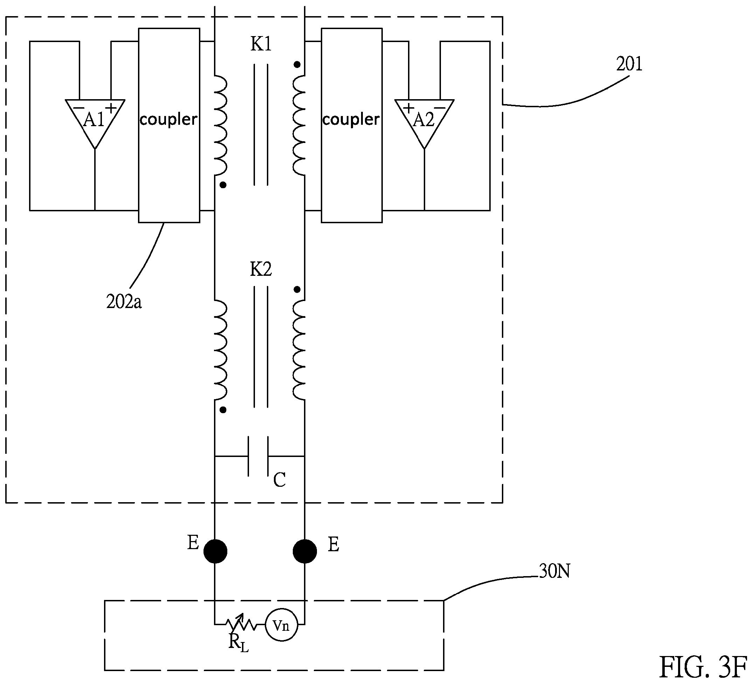

In addition, considering the presence of the voltage on the power line upon the practical application, a coupling circuit needs to be disposed between the amplifier circuit and the transformer (or inductor). In this embodiment, as shown in FIG. 3F, the path of the coupling circuit is generated through a coupler 202a. The isolator of this embodiment includes: two transformers K1 and K2 respectively serially connected to the power line; and two amplifiers A1 and A2 respectively coupled to the starting terminal of the primary-side coil and the starting terminal of the secondary-side coil of the transformer K1. The output terminals of the amplifiers A1 and A2 are respectively coupled between the inverting input terminals of the amplifiers A1 and A2, and the two transformers K1 and K2. The noninverting input terminals of the amplifiers A1 and A2 are respectively coupled to the starting terminal of the primary-side coil and the starting terminal of the secondary-side coil of the transformer K1. The power line at the high-voltage side is parallelly connected to a high-voltage capacitor C. That is, the high-voltage capacitor C is parallelly connected between the ending terminal of the primary-side coil and the ending terminal of the secondary-side coil of the transformer K2, and the power line. Two couplers 202a are respectively coupled to the starting terminal and the ending terminal of the transformer K1, and the output terminals, the noninverting input terminals and the inverting input terminals of the amplifiers A1 and A2, and are respectively disposed between the amplifiers A1 and A2 and the transformer K1.

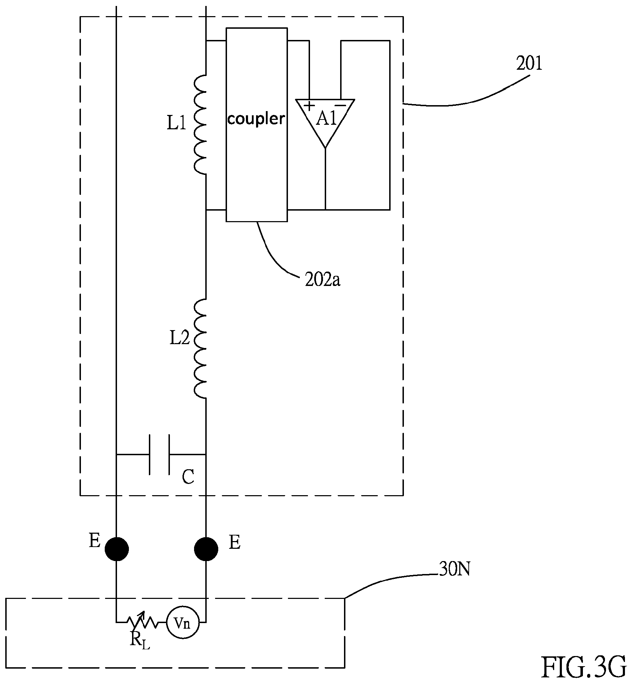

On the in-vehicle low-voltage power line, the coupling circuit may be implemented by a capacitor. In the application of the electricity meter, the coupling circuit is frequently implemented by a transformer, and the original coupling transformer at the side of the transmission terminal E may function as the input terminal of the amplifier. Only one coupling transformer needs to be added to achieve the objective, and the amplifier A1 may also be implemented by a differential amplifier. So, only one coupler 202a is needed in this embodiment, as shown in FIG. 3G. In this embodiment, two inductors L1 and L2 are serially connected to a same side of the power line; the input terminal of the amplifier A1 is coupled to the starting terminal of the first inductor L1, and the output terminal of the amplifier A1 is coupled to the inverting input terminal of the amplifier A1 and the ending terminal of the first inductor; the coupler 202a is coupled to the starting terminal and the ending terminal of the inductor L1, and is disposed between the amplifier A1 and the inductor L1, wherein the coupler 202a is coupled to the noninverting input terminal of the amplifier A1 and the starting terminal of the inductor L1, and the coupler 202a is coupled to the inverting input terminal and the output terminal of the amplifier A1, and the ending terminal of the inductor L1; and the capacitor C is parallelly connected to the power line. That is, the capacitor C is parallelly connected between the ending terminal of the inductor L2 and the power line.

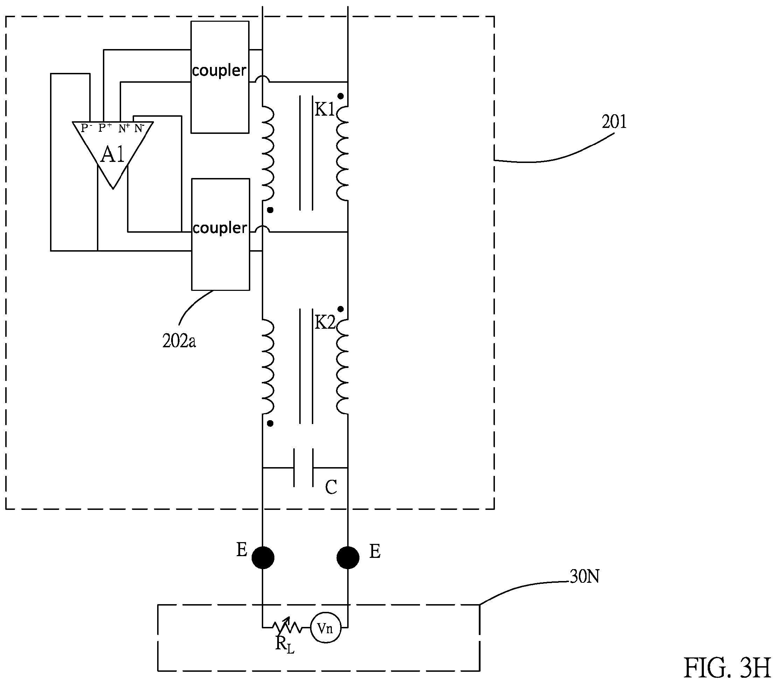

Referring to FIG. 3H, the transformers K1 and K2 in one embodiment may share an amplifier A1. So, two couplers 202a are provided in this embodiment so that the power line on two sides are respectively coupled to the same amplifier A1 through coupling paths, and the amplifier A1 has a first noninverting input terminal P⁺, a second noninverting input terminal P⁻, a first inverting input terminal N⁺ and a second inverting input terminal N⁻. The isolator 201 includes two transformers K1 and K2 respectively serially connected to the power line. The amplifier A1 is coupled to the starting terminal of the primary-side coil and the starting terminal of the secondary-side coil of the transformer K1, and two output terminals of the amplifier A1 are respectively coupled between the second noninverting input terminal P⁻ and the second inverting input terminal N⁻ of the amplifier A1, and the transformers K1 and K2. The capacitor C is parallelly connected between the ending terminal of the transformer K2 and the power line. The coupler 202a is coupled to the starting terminal of the transformer K1 and the first noninverting input terminal P⁺ and the first inverting input terminal N⁺ of the amplifier A1. The other coupler 202a is coupled to the ending terminal of the transformer K1, the output terminal of the amplifier A1, the second noninverting input terminal P⁻ and the second inverting input terminal N⁻. The two second couplers 202a are disposed between the amplifier A1 and the transformer K1.

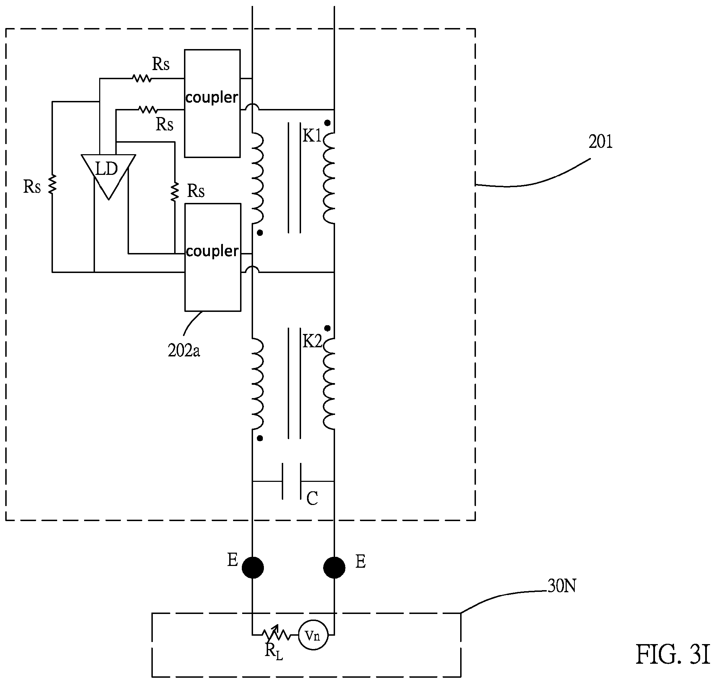

Referring to FIG. 3I, a line driver LD in one embodiment is coupled to the power line, and matching resistors Rs are disposed in feedback circuits between the input terminals and the output terminals of the line driver LD. The isolator 201 includes transformers K1 and K2 respectively serially connected to the power line. The matching resistor Rs functions as impedance matching and is coupled between the starting terminal and the ending terminal of the transformer K1. The line driver LD has input terminals coupled to the starting terminal of the transformer K1 and the matching resistor Rs, and output terminals coupled to the two input terminals of the line driver LD and the transformer K1, the positive signal terminal of the power line is coupled to the reverse output terminal of the line driver LD, and the reverse signal terminal of the power line is coupled to the positive output terminal of the line driver LD. The capacitor C is parallelly connected to the power line. The coupler 202a is coupled to the starting terminal of the transformer K1 and the input terminal of the line driver LD, and the other coupler 202a is coupled to the ending terminal of the transformer K1 and the output terminal of the line driver LD.

In one embodiment, the isolator 14 may be implemented by the active isolators of FIGS. 3C to 3I, and the principles thereof are the same.

The architecture of this disclosure may be applied to, for example but without limitation to, a long-distance power grid, a household/commercial indoor power grid, a battery-powered system network (e.g., an in-vehicle power grid or a photovoltaic power grid) and the like.

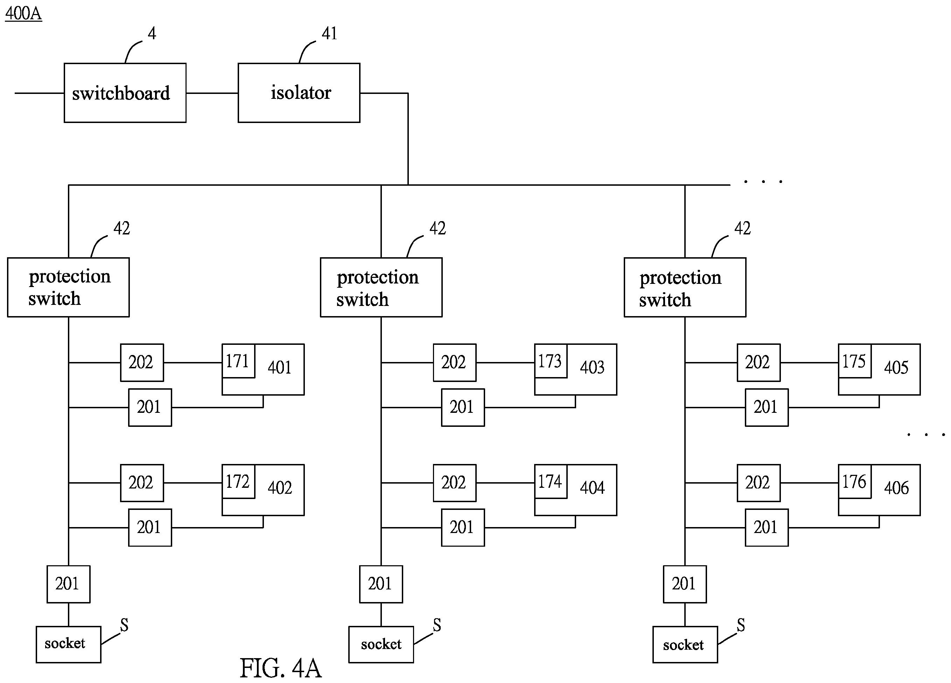

FIG. 4A is a schematic view showing the circuit structure of this disclosure applied to a household indoor power grid 400A. Referring to FIG. 4A, the circuit structure of this disclosure is used in the household indoor power grid 400A, and the power energy wave enters the house from the electric power company, is measured by the electricity meter, then enters the incoming line switch, and is then transmitted to a switchboard 4 through wires. The household indoor power grid 400A has multiple home appliances 401 to 406, which may be regarded as the power consumption units. Each home appliance has corresponding communication units 171 to 176. In addition, the household indoor power grid 400A includes an isolator 41, which can filter the high-frequency noise and clutters, coming from other fields or home appliances, to decrease the interference and noise of the home appliances 401 to 406, thereby protecting the home appliances 401 to 406 and circuits so that they can work stably.

In one embodiment, the isolator 41 may be implemented by a low-pass filter having a rated current of 60A, and a protection switch 42 may be disposed in front of each field of the household indoor power grid 400A. The protection switch 42 can detect problems including the abnormal current, voltage, power and the like in the power line, and automatically cut off the power line circuit to avoid problems including apparatus overloading, short-circuiting, current leakage and the like. In one embodiment, the isolator 41 may be implemented by the active isolator in each of FIGS. 3C to 3I, and the principles thereof are the same.

Please note that, as previously mentioned, each of the home appliances 401 to 406 is coupled to the isolator 201, and the communication units 171 to 176 in the home appliances 401 to 406 are also coupled to the coupler 202, so that the power energy wave and the network signal of the household indoor power grid 400A can enter the power consumption terminal and the transmission terminal, respectively. Consequently, the network signal is transmitted to the entrances of the communication units 171 to 176 (or transmission terminals) through the coupling path, but cannot enter the side of the power consumption terminal through the isolator 201, while the low-frequency power energy wave can pass through the isolator 201 and then enter the side of the power consumption terminal. The power energy wave provides the energy to the home appliances 401 to 406, wherein other principles are the same as those described hereinabove, and detailed descriptions thereof will be omitted here.

In addition, a socket S may be disposed in the field, the socket S is coupled to the power line, and an isolator 201 is disposed between the socket S and the power line to reduce the noise and impedance caused by the socket S.

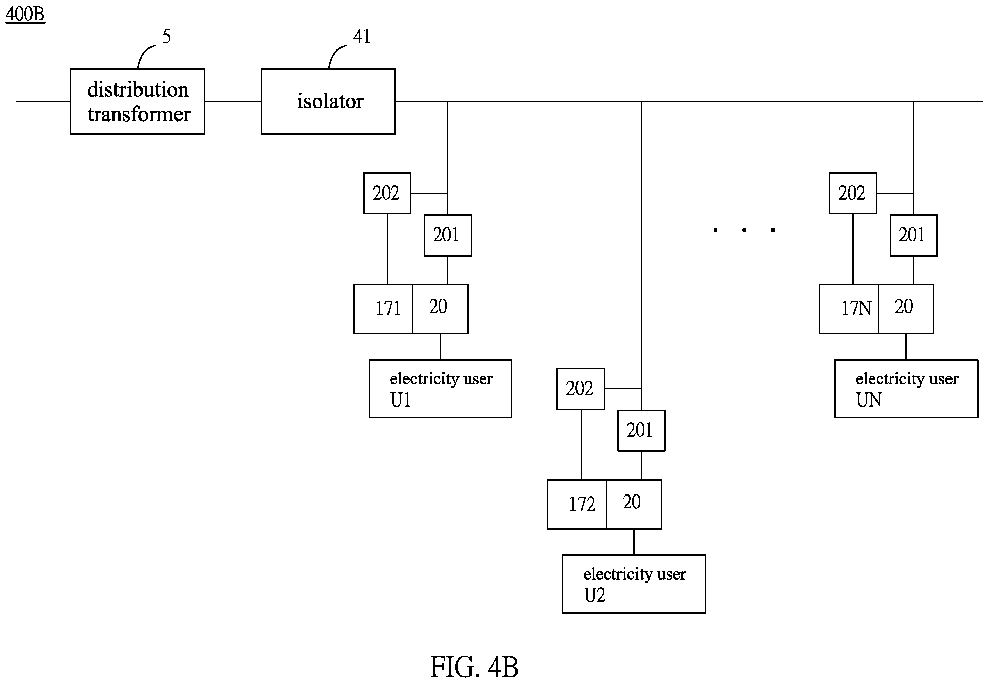

FIG. 4B is a schematic view showing the circuit structure of this disclosure used in an outdoor power grid 400B. Referring to FIG. 4B, the circuit structure of this disclosure is used in the outdoor power grid 400B, and the power energy wave passes through the electricity meter 20 from a distribution transformer 5, and is then transmitted to electricity users U1 to UN through the power line. The outdoor power grid 400B includes an isolator 41 capable of filtering high-frequency noise and clutters coming from other fields. As previously mentioned, the isolator 201 of this disclosure is disposed at an entrance of the electricity meter 20, and the communication units 171 to 17N are also coupled to the coupler 202. Consequently, the network signal is transmitted to entrances of the communication units 171 to 17N (or transmission terminals) through coupling paths, but cannot enter the electricity meter 20 through the isolator 201.

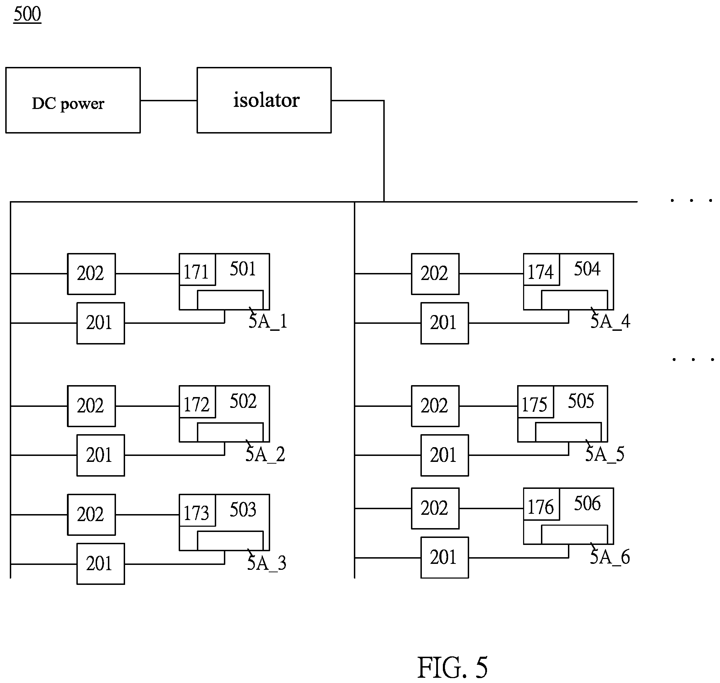

FIG. 5 is a schematic view showing the circuit structure of this disclosure used in a vehicle power grid 500. Referring to FIG. 5, the circuit structure of this disclosure is used in the vehicle power grid 500. The DC power is used by application modules 501 to 506 of the vehicle. The application modules 501 to 506 respectively have corresponding in-vehicle power consumption units 5A_1 to 5A_6, and communication units 171 to 176 corresponding to the application modules 501 to 506, respectively.

Please note that the application modules 501 to 506 may be implemented by an engine control unit (ECU), a transmission control unit, an electronic stability program, an active cruise control (ACC) system, a car access system, a car door module, a car window module, a rearview mirror module, a global positioning system (GPS), a radio module and the like.

This embodiment is explained according to the DC power for powering the automotive application modules 501 to 506. As previously mentioned, the in-vehicle power consumption units 5A_1 to 5A_6 in the vehicle power grid 500 may be the power consumption terminals or the power consumption units, the isolator 201 is coupled to the entrance of each of the in-vehicle power consumption units 5A_1 to 5A_6, and the coupler 202 is coupled to each of the communication units 171 to 176 or transmission terminals. Consequently, the network signal is transmitted to entrances of the communication units 171 to 176 (or transmission terminals) through coupling paths, but cannot enter the side of the power consumption terminal through the isolator 201. The low-frequency power energy wave can pass through the isolator 201 and then enter the side of the power consumption terminal. The power energy wave provides the energy to the in-vehicle power consumption units 5A_1 to 5A_6. The other principles are the same as those mentioned hereinabove, and detailed descriptions thereof will be omitted here.

In addition, the ground wire of the vehicle is generally replaced by the car shell, the DC electricity is generally supplied from the power cable (line) to each application module, and then the DC electricity flows back to the battery from the car-shell ground wire nearby. If the network signal is also transmitted in the same loop, then the signal tends to radiate, and the external interference noise is also absorbed by the transmission line. So, it is more proper that the differential signal is transmitted using the cable such as twist pairs. That is, the DC current loop still inherits from the original car shell loop, but the network signal flows back through the twisted-pair loop. At this time, the differential signal transmission line can be used to serve as the same set of DC power cables or two sets of power cables (e.g., one cable of 3.3V, and the other cable of 24V), and the requirement on the power chip on each application module can be properly reduced.

The circuit structure of this disclosure may also be applied to non-PLC. That is, the communication signal is transmitted through any wire similar to the twisted pairs or coaxial cable. In addition, the above-mentioned figures are mainly schematically depicted by way of differential signal transmission, but they may also be applied to a single-end signal cable or a single-end transmission line.

In summary, regarding the low-frequency power line and the high-frequency communication signal in this disclosure, another coupling path is configured on the transmission path, so that the low-frequency power line and the high-frequency communication signal have the isolated transmission paths to improve the power line communication (PLC).

## Claims

1. A circuit structure to improve reliability of power line communication, the circuit structure having a power line, on which a power energy wave and a network signal are transmitted, the circuit structure comprising:
a first isolator (201), which is disposed at an entrance of a power consumption terminal (E) of the circuit structure, separates the power line into the power consumption terminal (E) and a transmission terminal (T), and filters the network signal, so that the power energy wave enters the power consumption terminal (E); and
a first coupler (202) for generating a first coupling path, through which the network signal enters the transmission terminal (T) via the first coupler (202) without passing through the first isolator (201),
wherein power line impedance at a side of the transmission terminal (T) is not affected by a side of the power consumption terminal (E); time-varying noise and impedance generated by the power consumption terminal are substantially isolated at the power consumption terminal without entering the transmission terminal; and a cut-off frequency of the first isolator (201) is lower than a transmission frequency of the network signal, and higher than a frequency of the power energy wave; and the first isolator (201) comprises: an inductor (L1) serially connected to the power line; and
an amplifier (A1) coupled to two sides of the inductor (L1), wherein a noninverting input terminal of the amplifier (A1) is coupled to a starting terminal of the inductor (L1), and an output terminal of the amplifier (A1) is coupled to an inverting input terminal of the amplifier and an ending terminal of the inductor (L1).

2. A circuit structure to improve reliability of power line communication, the circuit structure having a power line, on which a power energy wave and a network signal are transmitted, the circuit structure comprising:
a first isolator (201), which is disposed at an entrance of a power consumption terminal (E) of the circuit structure, separates the power line into the power consumption terminal (E) and a transmission terminal (T), and filters the network signal, so that the power energy wave enters the power consumption terminal (E); and
a first coupler (202) for generating a first coupling path, through which the network signal enters the transmission terminal (T) via the first coupler (202) without passing through the first isolator (201),
wherein power line impedance at a side of the transmission terminal (T) is not affected by a side of the power consumption terminal (E); time-varying noise and impedance generated by the power consumption terminal are substantially isolated at the power consumption terminal without entering the transmission terminal; and a cut-off frequency of the first isolator (201) is lower than a transmission frequency of the network signal, and higher than a frequency of the power energy wave; and the first isolator (201) comprises: a transformer (K1) serially connected to the power line; and
two amplifiers (A1, A2) respectively coupled to a starting terminal of a primary-side coil and a starting terminal of a secondary-side coil of the transformer (K1), wherein output terminals of the amplifiers (A1, A2) are respectively coupled to inverting input terminals of the amplifiers (A1, A2), and an ending terminal of a primary-side coil or an ending terminal of a secondary-side coil of the transformer (K1), and noninverting input terminals of the amplifiers (A1, A2) are respectively coupled to the starting terminal of the primary-side coil and the starting terminal of the secondary-side coil of the transformer (K1).

3. A circuit structure to improve reliability of power line communication, the circuit structure having a power line, on which a power energy wave and a network signal are transmitted, the circuit structure comprising:
a first isolator (201), which is disposed at an entrance of a power consumption terminal (E) of the circuit structure, separates the power line into the power consumption terminal (E) and a transmission terminal (T), and filters the network signal, so that the power energy wave enters the power consumption terminal (E); and
a first coupler (202) for generating a first coupling path, through which the network signal enters the transmission terminal (T) via the first coupler (202) without passing through the first isolator (201),
wherein power line impedance at a side of the transmission terminal (T) is not affected by a side of the power consumption terminal (E); time-varying noise and impedance generated by the power consumption terminal are substantially isolated at the power consumption terminal without entering the transmission terminal; and a cut-off frequency of the first isolator (201) is lower than a transmission frequency of the network signal, and higher than a frequency of the power energy wave; and the first isolator (201) comprises: two transformers (K1, K2) respectively serially connected to the power line; and two amplifiers (A1, A2) respectively coupled to a starting terminal of a primary-side coil and a starting terminal of a secondary-side coil of a first transformer (K1) of the transformers (K1, K2), wherein: output terminals of the amplifiers (A1, A2) are respectively coupled between inverting input terminals of the amplifiers (A1, A2), and the two transformers (K1, K2); and noninverting input terminals of the amplifiers (A1, A2) are respectively coupled to the starting terminal of the primary-side coil and the starting terminal of the secondary-side coil of the first transformer (K1); and multiple capacitors (C) respectively parallelly connected between the starting terminal of the primary-side coil or the starting terminal of the secondary-side coil of the first transformer (K1), the noninverting input terminals of the amplifiers (A1, A2) and the power line, and parallelly connected between an ending terminal of the primary-side coil of the first transformer (K1) or an ending terminal of the secondary-side coil of the first transformer (K1), the inverting input terminals and the output terminals of the amplifiers (A1, A2), and the power line; wherein the power line at a high-voltage side is parallelly connected to another one of the capacitors (C).

4. A circuit structure to improve reliability of power line communication, the circuit structure having a power line, on which a power energy wave and a network signal are transmitted, the circuit structure comprising:
a first isolator (201), which is disposed at an entrance of a power consumption terminal (E) of the circuit structure, separates the power line into the power consumption terminal (E) and a transmission terminal (T), and filters the network signal, so that the power energy wave enters the power consumption terminal (E); and
a first coupler (202) for generating a first coupling path, through which the network signal enters the transmission terminal (T) via the first coupler (202) without passing through the first isolator (201),
wherein power line impedance at a side of the transmission terminal (T) is not affected by a side of the power consumption terminal (E); time-varying noise and impedance generated by the power consumption terminal are substantially isolated at the power consumption terminal without entering the transmission terminal; and a cut-off frequency of the first isolator (201) is lower than a transmission frequency of the network signal, and higher than a frequency of the power energy wave; and the first isolator (201) comprises: two transformers (K1, K2) respectively serially connected to the power line;
two amplifiers (A1, A2) respectively coupled to a starting terminal of a primary-side coil and a starting terminal of a secondary-side coil of a first transformer (K1) of the transformers (K1, K2), wherein output terminals of the amplifiers (A1, A2) are respectively coupled between inverting input terminals of the amplifiers (A1, A2), and the two transformers (K1, K2), wherein noninverting input terminals of the amplifiers (A1, A2) are respectively coupled to the starting terminal of the primary-side coil and the starting terminal of the secondary-side coil of the first transformer (K1) of the transformers (K1, K2);
a capacitor (C) parallelly connected between the power line at a high-voltage side, an ending terminal of a primary-side coil and an ending terminal of a secondary-side coil of a second transformer (K2) of the transformers (K1, K2), and the power line; and
a second coupler (202a), which is coupled to the starting terminal and the ending terminal of the first transformer (K1), and the output terminals, the noninverting input terminals and the inverting input terminals of the amplifiers (A1, A2), and disposed between the amplifiers (A1, A2) and the first transformer (K1).

5. A circuit structure to improve reliability of power line communication, the circuit structure having a power line, on which a power energy wave and a network signal are transmitted, the circuit structure comprising:
a first isolator (201), which is disposed at an entrance of a power consumption terminal (E) of the circuit structure, separates the power line into the power consumption terminal (E) and a transmission terminal (T), and filters the network signal, so that the power energy wave enters the power consumption terminal (E); and
a first coupler (202) for generating a first coupling path, through which the network signal enters the transmission terminal (T) via the first coupler (202) without passing through the first isolator (201),
wherein power line impedance at a side of the transmission terminal (T) is not affected by a side of the power consumption terminal (E); time-varying noise and impedance generated by the power consumption terminal are substantially isolated at the power consumption terminal without entering the transmission terminal; and a cut-off frequency of the first isolator (201) is lower than a transmission frequency of the network signal, and higher than a frequency of the power energy wave; and the first isolator (201) comprises: two inductors (L1, L2) serially connected to a same side of the power line;
an amplifier (A1), wherein an input terminal of the amplifier (A1) is coupled to a starting terminal of a first inductor (L1) of the inductors (L1, L2), and an output terminal of the amplifier (A1) is coupled to an inverting input terminal of the amplifier (A1) and an ending terminal of the first inductor (L1);
a second coupler (202a) coupled to a noninverting input terminal of the amplifier (A1) and the starting terminal of the first inductor (L1) of the inductors (L1, L2), wherein the second coupler (202a) is coupled to an inverting input terminal and an output terminal of the amplifier (A1), and the ending terminal of the first inductor (L1); and
a capacitor (C) parallelly connected to the power line.

6. A circuit structure to improve reliability of power line communication, the circuit structure having a power line, on which a power energy wave and a network signal are transmitted, the circuit structure comprising:
a first isolator (201), which is disposed at an entrance of a power consumption terminal (E) of the circuit structure, separates the power line into the power consumption terminal (E) and a transmission terminal (T), and filters the network signal, so that the power energy wave enters the power consumption terminal (E); and
a first coupler (202) for generating a first coupling path, through which the network signal enters the transmission terminal (T) via the first coupler (202) without passing through the first isolator (201),
wherein power line impedance at a side of the transmission terminal (T) is not affected by a side of the power consumption terminal (E); time-varying noise and impedance generated by the power consumption terminal are substantially isolated at the power consumption terminal without entering the transmission terminal; and a cut-off frequency of the first isolator (201) is lower than a transmission frequency of the network signal, and higher than a frequency of the power energy wave; and the first isolator (201) comprises: two transformers (K1, K2) respectively serially connected to the power line; and an amplifier (A1) having a first noninverting input terminal (P⁺), a second noninverting input terminal (P⁻), a first inverting input terminal (N⁺) and a second inverting input terminal, wherein the amplifier (A1) is coupled to a starting terminal of a primary-side coil and a starting terminal of a secondary-side coil of a first transformer (K1) of the transformers (K1, K2), and an output terminal of the amplifier (A1) is coupled between the second noninverting input terminal (P⁻) and the second inverting input terminal (N⁻) of the amplifier (A1), and the two transformers (K1, K2);
a capacitor parallelly connected between a second transformer (K2) of the transformers (K1, K2) and the power line; and
two second couplers (202a), wherein one of the second couplers (202a) is coupled to the starting terminal of the first transformer (K1) and the first noninverting input terminal (P⁺) and the first inverting input terminal (N⁺) of the amplifier (A1), and the other one of the second couplers (202a) is coupled to an ending terminal of the first transformer (K1), and the second noninverting input terminal (P⁻), the second inverting input terminal (N⁻) and the output terminal of the amplifier (A1), and is disposed between the amplifier (A1) and the first transformer (K1).

7. A circuit structure to improve reliability of power line communication, the circuit structure having a power line, on which a power energy wave and a network signal are transmitted, the circuit structure comprising:
a first isolator (201), which is disposed at an entrance of a power consumption terminal (E) of the circuit structure, separates the power line into the power consumption terminal (E) and a transmission terminal (T), and filters the network signal, so that the power energy wave enters the power consumption terminal (E); and
a first coupler (202) for generating a first coupling path, through which the network signal enters the transmission terminal (T) via the first coupler (202) without passing through the first isolator (201),
wherein power line impedance at a side of the transmission terminal (T) is not affected by a side of the power consumption terminal (E); time-varying noise and impedance generated by the power consumption terminal are substantially isolated at the power consumption terminal without entering the transmission terminal; and a cut-off frequency of the first isolator (201) is lower than a transmission frequency of the network signal, and higher than a frequency of the power energy wave; and the first isolator (201) comprises: two transformers (K1, K2) respectively serially connected to the power line;
four matching resistors (Rs), which function as impedance matching and are respectively coupled between a starting terminal and an ending terminal of the first transformer (K1) of the transformers (K1, K2);
a line driver (LD) having input terminals coupled to the starting terminal of the first transformer (K1) and the matching resistor (Rs), output terminals coupled to the two input terminals of the line driver (LD) and the first transformer (K1), a positive signal terminal of the power line coupled to a reverse output terminal of the line driver (LD), and a reverse signal terminal of the power line coupled to a positive output terminal of the line driver (LD);
a capacitor (C) parallelly connected to the power line (LD); and
two second couplers (202a), wherein one of the second couplers (202a) is coupled to the starting terminal of the first transformer (K1) and the input terminals of the line driver (LD), and the other one of the second couplers (202a) is coupled to the ending terminal of the first transformer (K1) and the output terminals of the line driver (LD).

## Patentansprüche

1. Schaltungsstruktur zur Verbesserung der Zuverlässigkeit von Stromleitungskommunikation, wobei die Schaltungsstruktur eine Stromleitung aufweist, auf der eine Stromenergiewelle und ein Netzwerksignal übertragen werden, wobei die Schaltungsstruktur umfasst:
einen ersten Isolator (201), der an einem Eingang eines Stromverbrauchanschlusses (E) der Schaltungsstruktur angeordnet ist, die Stromleitung in den Stromverbrauchanschluss (E) und einen Übertragungsanschluss (T) trennt, und das Netzwerksignal filtert, sodass die Stromenergiewelle in den Stromverbrauchanschluss (E) eintritt; und
einen ersten Koppler (202) zur Erzeugung eines ersten Kopplungspfades, durch den das Netzwerksignal über den ersten Koppler (202) in den Übertragungsanschluss (T) eintritt, ohne den ersten Isolator (201) zu durchlaufen,
wobei die Stromleitungsimpedanz auf einer Seite des Übertragungsanschlusses (T) nicht von einer Seite des Stromverbrauchanschlusses (E) beeinflusst wird; zeitlich veränderliches Rauschen und Impedanz, die durch den Stromverbrauchanschluss erzeugt werden, am Stromverbrauchanschluss im Wesentlichen isoliert werden, ohne in den Übertragungsanschluss einzutreten; und eine Grenzfrequenz des ersten Isolators (201) niedriger als eine Übertragungsfrequenz des Netzwerksignals und höher als eine Frequenz der Stromenergiewelle ist; und der erste Isolator (201) umfasst:
einen Induktor (L1), der in Reihe mit der Stromleitung verbunden ist; und
einen Verstärker (A1), der mit zwei Seiten des Induktors (L1) gekoppelt ist, wobei ein nicht-invertierender Eingangsanschluss des Verstärkers (A1) mit einem Anfangsanschluss des Induktors (L1) gekoppelt ist, und ein Ausgangsanschluss des Verstärkers (A1) mit einem invertierenden Eingangsanschluss des Verstärkers und einem Endanschluss des Induktors (L1) gekoppelt ist.

2. Schaltungsstruktur zur Verbesserung der Zuverlässigkeit von Stromleitungskommunikation, wobei die Schaltungsstruktur eine Stromleitung aufweist, auf der eine Stromenergiewelle und ein Netzwerksignal übertragen werden, wobei die Schaltungsstruktur umfasst:
einen ersten Isolator (201), der an einem Eingang eines Stromverbrauchanschlusses (E) der Schaltungsstruktur angeordnet ist, die Stromleitung in den Stromverbrauchanschluss (E) und einen Übertragungsanschluss (T) trennt, und das Netzwerksignal filtert, sodass die Stromenergiewelle in den Stromverbrauchanschluss (E) eintritt; und
einen ersten Koppler (202) zur Erzeugung eines ersten Kopplungspfades, durch den das Netzwerksignal über den ersten Koppler (202) in den Übertragungsanschluss (T) eintritt, ohne den ersten Isolator (201) zu durchlaufen,
wobei die Stromleitungsimpedanz auf einer Seite des Übertragungsanschlusses (T) nicht von einer Seite des Stromverbrauchanschlusses (E) beeinflusst wird; zeitlich veränderliches Rauschen und Impedanz, die durch den Stromverbrauchanschluss erzeugt werden, am Stromverbrauchanschluss im Wesentlichen isoliert werden, ohne in den Übertragungsanschluss einzutreten; und eine Grenzfrequenz des ersten Isolators (201) niedriger als eine Übertragungsfrequenz des Netzwerksignals und höher als eine Frequenz der Stromenergiewelle ist; und der erste Isolator (201) umfasst:
einen Transformator (K1), der in Reihe mit der Stromleitung verbunden ist; und zwei Verstärker (A1, A2), die jeweils mit einem Anfangsanschluss einer primärseitigen Spule und einem Anfangsanschluss einer sekundärseitigen Spule des Transformators (K1) gekoppelt sind, wobei Ausgangsanschlüsse der Verstärker (A1, A2) jeweils mit invertierenden Eingangsanschlüssen der Verstärker (A1, A2) und einem Endanschluss einer primärseitigen Spule oder einem Endanschluss einer sekundärseitigen Spule des Transformators (K1) gekoppelt sind, und nicht-invertierende Eingangsanschlüsse der Verstärker (A1, A2) jeweils mit dem Anfangsanschluss der primärseitigen Spule und dem Anfangsanschluss der sekundärseitigen Spule des Transformators (K1) gekoppelt sind.

3. Schaltungsstruktur zur Verbesserung der Zuverlässigkeit von Stromleitungskommunikation, wobei die Schaltungsstruktur eine Stromleitung aufweist, auf der eine Stromenergiewelle und ein Netzwerksignal übertragen werden, wobei die Schaltungsstruktur umfasst:
einen ersten Isolator (201), der an einem Eingang eines Stromverbrauchanschlusses (E) der Schaltungsstruktur angeordnet ist, die Stromleitung in den Stromverbrauchanschluss (E) und einen Übertragungsanschluss (T) trennt, und das Netzwerksignal filtert, sodass die Stromenergiewelle in den Stromverbrauchanschluss (E) eintritt; und
einen ersten Koppler (202) zur Erzeugung eines ersten Kopplungspfades, durch den das Netzwerksignal über den ersten Koppler (202) in den Übertragungsanschluss (T) eintritt, ohne den ersten Isolator (201) zu durchlaufen,
wobei die Stromleitungsimpedanz auf einer Seite des Übertragungsanschlusses (T) nicht von einer Seite des Stromverbrauchanschlusses (E) beeinflusst wird; zeitlich veränderliches Rauschen und Impedanz, die durch den Stromverbrauchanschluss erzeugt werden, am Stromverbrauchanschluss im Wesentlichen isoliert werden, ohne in den Übertragungsanschluss einzutreten; und eine Grenzfrequenz des ersten Isolators (201) niedriger als eine Übertragungsfrequenz des Netzwerksignals und höher als eine Frequenz der Stromenergiewelle ist; und der erste Isolator (201) umfasst:
zwei Transformatoren (K1, K2), die jeweils in Reihe mit der Stromleitung verbunden sind; und zwei Verstärker (A1, A2), die jeweils mit einem Anfangsanschluss einer primärseitigen Spule und einem Anfangsanschluss einer sekundärseitigen Spule eines ersten Transformators (K1) der Transformatoren (K1, K2) gekoppelt sind, wobei: Ausgangsanschlüsse der Verstärker (A1, A2) jeweils zwischen invertierenden Eingangsanschlüssen der Verstärker (A1, A2) und den zwei Transformatoren (K1, K2) gekoppelt sind; und nicht-invertierende Eingangsanschlüsse der Verstärker (A1, A2) jeweils mit dem Anfangsanschluss der primärseitigen Spule und dem Anfangsanschluss der sekundärseitigen Spule des ersten Transformators (K1) gekoppelt sind; und
mehrere Kondensatoren (C), die jeweils parallel zwischen dem Anfangsanschluss der primärseitigen Spule oder dem Anfangsanschluss der sekundärseitigen Spule des ersten Transformators (K1), den nicht-invertierenden Eingangsanschlüssen der Verstärker (A1, A2) und der Stromleitung geschaltet sind, und parallel zwischen einem Endanschluss der primärseitigen Spule des ersten Transformators (K1) oder einem Endanschluss der sekundärseitigen Spule des ersten Transformators (K1), den invertierenden Eingangsanschlüssen und den Ausgangsanschlüssen der Verstärker (A1, A2) und der Stromleitung geschaltet sind; wobei die Stromleitung auf einer Hochspannungsseite parallel zu einem weiteren der Kondensatoren (C) geschaltet ist.

4. Schaltungsstruktur zur Verbesserung der Zuverlässigkeit von Stromleitungskommunikation, wobei die Schaltungsstruktur eine Stromleitung aufweist, auf der eine Stromenergiewelle und ein Netzwerksignal übertragen werden, wobei die Schaltungsstruktur umfasst:
einen ersten Isolator (201), der an einem Eingang eines Stromverbrauchanschlusses (E) der Schaltungsstruktur angeordnet ist, die Stromleitung in den Stromverbrauchanschluss (E) und einen Übertragungsanschluss (T) trennt, und das Netzwerksignal filtert, sodass die Stromenergiewelle in den Stromverbrauchanschluss (E) eintritt; und
einen ersten Koppler (202) zur Erzeugung eines ersten Kopplungspfades, durch den das Netzwerksignal über den ersten Koppler (202) in den Übertragungsanschluss (T) eintritt, ohne den ersten Isolator (201) zu durchlaufen,
wobei die Stromleitungsimpedanz auf einer Seite des Übertragungsanschlusses (T) nicht von einer Seite des Stromverbrauchanschlusses (E) beeinflusst wird; zeitlich veränderliches Rauschen und Impedanz, die durch den Stromverbrauchanschluss erzeugt werden, am Stromverbrauchanschluss im Wesentlichen isoliert werden, ohne in den Übertragungsanschluss einzutreten; und eine Grenzfrequenz des ersten Isolators (201) niedriger als eine Übertragungsfrequenz des Netzwerksignals und höher als eine Frequenz der Stromenergiewelle ist; und der erste Isolator (201) umfasst:
zwei Transformatoren (K1, K2), die jeweils in Reihe mit der Stromleitung verbunden sind; zwei Verstärker (A1, A2), die jeweils mit einem Anfangsanschluss einer primärseitigen Spule und einem Anfangsanschluss einer sekundärseitigen Spule eines ersten Transformators (K1) der Transformatoren (K1, K2) gekoppelt sind, wobei Ausgangsanschlüsse der Verstärker (A1, A2) jeweils zwischen invertierenden Eingangsanschlüssen der Verstärker (A1, A2) und den zwei Transformatoren (K1, K2) gekoppelt sind, wobei nicht-invertierende Eingangsanschlüsse der Verstärker (A1, A2) jeweils mit dem Anfangsanschluss der primärseitigen Spule und dem Anfangsanschluss der sekundärseitigen Spule des ersten Transformators (K1) der Transformatoren (K1, K2) gekoppelt sind;
einen Kondensator (C), der parallel zwischen der Stromleitung auf einer Hochspannungsseite, einem Endanschluss einer primärseitigen Spule und einem Endanschluss einer sekundärseitigen Spule eines zweiten Transformators (K2) der Transformatoren (K1, K2) und der Stromleitung geschaltet ist; und
einen zweiten Koppler (202a), der mit dem Anfangsanschluss und dem Endanschluss des ersten Transformators (K1) sowie den Ausgangsanschlüssen, den nicht-invertierenden Eingangsanschlüssen und den invertierenden Eingangsanschlüssen der Verstärker (A1, A2) gekoppelt ist und zwischen den Verstärkern (A1, A2) und dem ersten Transformator (K1) angeordnet ist.

5. Schaltungsstruktur zur Verbesserung der Zuverlässigkeit von Stromleitungskommunikation, wobei die Schaltungsstruktur eine Stromleitung aufweist, auf der eine Stromenergiewelle und ein Netzwerksignal übertragen werden, wobei die Schaltungsstruktur umfasst:
einen ersten Isolator (201), der an einem Eingang eines Stromverbrauchanschlusses (E) der Schaltungsstruktur angeordnet ist, die Stromleitung in den Stromverbrauchanschluss (E) und einen Übertragungsanschluss (T) trennt, und das Netzwerksignal filtert, sodass die Stromenergiewelle in den Stromverbrauchanschluss (E) eintritt; und
einen ersten Koppler (202) zur Erzeugung eines ersten Kopplungspfades, durch den das Netzwerksignal über den ersten Koppler (202) in den Übertragungsanschluss (T) eintritt, ohne den ersten Isolator (201) zu durchlaufen,
wobei die Stromleitungsimpedanz auf einer Seite des Übertragungsanschlusses (T) nicht von einer Seite des Stromverbrauchanschlusses (E) beeinflusst wird; zeitlich veränderliches Rauschen und Impedanz, die durch den Stromverbrauchanschluss erzeugt werden, am Stromverbrauchanschluss im Wesentlichen isoliert werden, ohne in den Übertragungsanschluss einzutreten; und eine Grenzfrequenz des ersten Isolators (201) niedriger als eine Übertragungsfrequenz des Netzwerksignals und höher als eine Frequenz der Stromenergiewelle ist; und der erste Isolator (201) umfasst:
zwei Induktoren (L1, L2), die in Reihe mit derselben Seite der Stromleitung verbunden sind; einen Verstärker (A1), wobei ein Eingangsanschluss des Verstärkers (A1) mit einem Anfangsanschluss eines ersten Induktors (L1) der Induktoren (L1, L2) gekoppelt ist, und ein Ausgangsanschluss des Verstärkers (A1) mit einem invertierenden Eingangsanschluss des Verstärkers (A1) und einem Endanschluss des ersten Induktors (L1) gekoppelt ist; einen zweiten Koppler (202a), der mit einem nicht-invertierenden Eingangsanschluss des Verstärkers (A1) und dem Anfangsanschluss des ersten Induktors (L1) der Induktoren (L1, L2) gekoppelt ist, wobei der zweite Koppler (202a) mit einem invertierenden Eingangsanschluss und einem Ausgangsanschluss des Verstärkers (A1) sowie dem Endanschluss des ersten Induktors (L1) gekoppelt ist; und
einen Kondensator (C), der parallel an die Stromleitung geschaltet ist.

6. Schaltungsstruktur zur Verbesserung der Zuverlässigkeit von Stromleitungskommunikation, wobei die Schaltungsstruktur eine Stromleitung aufweist, auf der eine Stromenergiewelle und ein Netzwerksignal übertragen werden, wobei die Schaltungsstruktur umfasst:
einen ersten Isolator (201), der an einem Eingang eines Stromverbrauchanschlusses (E) der Schaltungsstruktur angeordnet ist, die Stromleitung in den Stromverbrauchanschluss (E) und einen Übertragungsanschluss (T) trennt, und das Netzwerksignal filtert, sodass die Stromenergiewelle in den Stromverbrauchanschluss (E) eintritt; und
einen ersten Koppler (202) zur Erzeugung eines ersten Kopplungspfades, durch den das Netzwerksignal über den ersten Koppler (202) in den Übertragungsanschluss (T) eintritt, ohne den ersten Isolator (201) zu durchlaufen,
wobei die Stromleitungsimpedanz auf einer Seite des Übertragungsanschlusses (T) nicht von einer Seite des Stromverbrauchanschlusses (E) beeinflusst wird; zeitlich veränderliches Rauschen und Impedanz, die durch den Stromverbrauchanschluss erzeugt werden, am Stromverbrauchanschluss im Wesentlichen isoliert werden, ohne in den Übertragungsanschluss einzutreten; und eine Grenzfrequenz des ersten Isolators (201) niedriger als eine Übertragungsfrequenz des Netzwerksignals und höher als eine Frequenz der Stromenergiewelle ist; und der erste Isolator (201) umfasst:
zwei Transformatoren (K1, K2), die jeweils in Reihe mit der Stromleitung verbunden sind; und einen Verstärker (A1), der einen ersten nicht-invertierenden Eingangsanschluss (P⁺), einen zweiten nicht-invertierenden Eingangsanschluss (P⁻), einen ersten invertierenden Eingangsanschluss (N⁺) und einen zweiten invertierenden Eingangsanschluss aufweist, wobei der Verstärker (A1) mit einem Anfangsanschluss einer primärseitigen Spule und einem Anfangsanschluss einer sekundärseitigen Spule eines ersten Transformators (K1) der Transformatoren (K1, K2) gekoppelt ist, und ein Ausgangsanschluss des Verstärkers (A1) zwischen dem zweiten nicht-invertierenden Eingangsanschluss (P⁻) und dem zweiten invertierenden Eingangsanschluss (N⁻) des Verstärkers (A1) und den zwei Transformatoren (K1, K2) gekoppelt ist;
einen Kondensator, der parallel zwischen einem zweiten Transformator (K2) der Transformatoren (K1, K2) und der Stromleitung geschaltet ist; und
zwei zweite Koppler (202a), wobei einer der zweiten Koppler (202a) mit dem Anfangsanschluss des ersten Transformators (K1) und dem ersten nicht-invertierenden Eingangsanschluss (P⁺) sowie dem ersten invertierenden Eingangsanschluss (N⁺) des Verstärkers (A1) gekoppelt ist, und der andere der zweiten Koppler (202a) mit einem Endanschluss des ersten Transformators (K1) und dem zweiten nicht-invertierenden Eingangsanschluss (P⁻), dem zweiten invertierenden Eingangsanschluss (N⁻) und dem Ausgangsanschluss des Verstärkers (A1) gekoppelt ist und zwischen dem Verstärker (A1) und dem ersten Transformator (K1) angeordnet ist.

7. Schaltungsstruktur zur Verbesserung der Zuverlässigkeit von Stromleitungskommunikation, wobei die Schaltungsstruktur eine Stromleitung aufweist, auf der eine Stromenergiewelle und ein Netzwerksignal übertragen werden, wobei die Schaltungsstruktur umfasst:
einen ersten Isolator (201), der an einem Eingang eines Stromverbrauchanschlusses (E) der Schaltungsstruktur angeordnet ist, die Stromleitung in den Stromverbrauchanschluss (E) und einen Übertragungsanschluss (T) trennt, und das Netzwerksignal filtert, sodass die Stromenergiewelle in den Stromverbrauchanschluss (E) eintritt; und
einen ersten Koppler (202) zur Erzeugung eines ersten Kopplungspfades, durch den das Netzwerksignal über den ersten Koppler (202) in den Übertragungsanschluss (T) eintritt, ohne den ersten Isolator (201) zu durchlaufen,
wobei die Stromleitungsimpedanz auf einer Seite des Übertragungsanschlusses (T) nicht von einer Seite des Stromverbrauchanschlusses (E) beeinflusst wird; zeitlich veränderliches Rauschen und Impedanz, die durch den Stromverbrauchanschluss erzeugt werden, am Stromverbrauchanschluss im Wesentlichen isoliert werden, ohne in den Übertragungsanschluss einzutreten; und eine Grenzfrequenz des ersten Isolators (201) niedriger als eine Übertragungsfrequenz des Netzwerksignals und höher als eine Frequenz der Stromenergiewelle ist; und der erste Isolator (201) umfasst:
zwei Transformatoren (K1, K2), die jeweils in Reihe mit der Stromleitung verbunden sind; vier Anpassungswiderstände (Rs), die zur Impedanzanpassung dienen und jeweils zwischen einem Anfangsanschluss und einem Endanschluss des ersten Transformators (K1) der Transformatoren (K1, K2) gekoppelt sind;
einen Leitungstreiber (LD), der Eingangsanschlüsse, die mit dem Anfangsanschluss des ersten Transformators (K1) und dem Anpassungswiderstand (Rs) gekoppelt sind, Ausgangsanschlüsse, die mit den zwei Eingangsanschlüssen des Leitungstreibers (LD) und dem ersten Transformator (K1) gekoppelt sind, einen positiven Signalanschluss der Stromleitung, der mit einem invertierten Ausgangsanschluss des Leitungstreibers (LD) gekoppelt ist, und einen invertierten Signalanschluss der Stromleitung, der mit einem positiven Ausgangsanschluss des Leitungstreibers (LD) gekoppelt ist, aufweist;
einen Kondensator (C), der parallel an die Stromleitung geschaltet ist; und zwei zweite Koppler (202a), wobei einer der zweiten Koppler (202a) mit dem Anfangsanschluss des ersten Transformators (K1) und den Eingangsanschlüssen des Leitungstreibers (LD) gekoppelt ist, und der andere der zweiten Koppler (202a) mit dem Endanschluss des ersten Transformators (K1) und den Ausgangsanschlüssen des Leitungstreibers (LD) gekoppelt ist.

## Revendications

1. Une structure de circuit pour améliorer la fiabilité d'une communication par ligne électrique, la structure de circuit présentant une ligne électrique sur laquelle une onde d'énergie électrique et un signal de réseau sont transmis, la structure de circuit comprenant :
un premier isolateur (201), qui est disposé à une entrée d'une borne de consommation d'énergie (E) de la structure de circuit, sépare la ligne électrique en la borne de consommation d'énergie (E) et une borne de transmission (T), et filtre le signal de réseau, de sorte que l'onde d'énergie électrique entre dans la borne de consommation d'énergie (E) ; et
un premier coupleur (202) pour générer un premier chemin de couplage, à travers lequel le signal de réseau entre dans la borne de transmission (T) via le premier coupleur (202) sans passer par le premier isolateur (201),
dans laquelle l'impédance de la ligne électrique d'un côté de la borne de transmission (T) n'est pas affectée par un côté de la borne de consommation d'énergie (E) ; le bruit variable dans le temps et l'impédance générés par la borne de consommation d'énergie sont sensiblement isolés au niveau de la borne de consommation d'énergie sans entrer dans la borne de transmission ; et une fréquence de coupure du premier isolateur (201) est inférieure à une fréquence de transmission du signal de réseau, et supérieure à une fréquence de l'onde d'énergie électrique ; et le premier isolateur (201) comprend :
une inductance (L1) connectée en série à la ligne électrique ; et
un amplificateur (A1) couplé à deux côtés de l'inductance (L1), dans laquelle une borne d'entrée non inverseuse de l'amplificateur (A1) est couplée à une borne de départ de l'inductance (L1), et une borne de sortie de l'amplificateur (A1) est couplée à une borne d'entrée inverseuse de l'amplificateur et à une borne de fin de l'inductance (L1).

2. Une structure de circuit pour améliorer la fiabilité d'une communication par ligne électrique, la structure de circuit présentant une ligne électrique sur laquelle une onde d'énergie électrique et un signal de réseau sont transmis, la structure de circuit comprenant :
un premier isolateur (201), qui est disposé à une entrée d'une borne de consommation d'énergie (E) de la structure de circuit, sépare la ligne électrique en la borne de consommation d'énergie (E) et une borne de transmission (T), et filtre le signal de réseau, de sorte que l'onde d'énergie électrique entre dans la borne de consommation d'énergie (E) ; et
un premier coupleur (202) pour générer un premier chemin de couplage, à travers lequel le signal de réseau entre dans la borne de transmission (T) via le premier coupleur (202) sans passer par le premier isolateur (201),
dans laquelle l'impédance de la ligne électrique d'un côté de la borne de transmission (T) n'est pas affectée par un côté de la borne de consommation d'énergie (E) ; le bruit variable dans le temps et l'impédance générés par la borne de consommation d'énergie sont sensiblement isolés au niveau de la borne de consommation d'énergie sans entrer dans la borne de transmission ; et une fréquence de coupure du premier isolateur (201) est inférieure à une fréquence de transmission du signal de réseau, et supérieure à une fréquence de l'onde d'énergie électrique ; et le premier isolateur (201) comprend :
un transformateur (K1) connecté en série à la ligne électrique ; et
deux amplificateurs (A1, A2) couplés respectivement à une borne de départ d'une bobine côté primaire et à une borne de départ d'une bobine côté secondaire du transformateur (K1), dans laquelle les bornes de sortie des amplificateurs (A1, A2) sont respectivement couplées aux bornes d'entrée inverseuses des amplificateurs (A1, A2), et à une borne de fin d'une bobine côté primaire ou à une borne de fin d'une bobine côté secondaire du transformateur (K1), et les bornes d'entrée non inverseuses des amplificateurs (A1, A2) sont respectivement couplées à la borne de départ de la bobine côté primaire et à la borne de départ de la bobine côté secondaire du transformateur (K1).

3. Une structure de circuit pour améliorer la fiabilité d'une communication par ligne électrique, la structure de circuit présentant une ligne électrique sur laquelle une onde d'énergie électrique et un signal de réseau sont transmis, la structure de circuit comprenant :
un premier isolateur (201), qui est disposé à une entrée d'une borne de consommation d'énergie (E) de la structure de circuit, sépare la ligne électrique en la borne de consommation d'énergie (E) et une borne de transmission (T), et filtre le signal de réseau, de sorte que l'onde d'énergie électrique entre dans la borne de consommation d'énergie (E) ; et
un premier coupleur (202) pour générer un premier chemin de couplage, à travers lequel le signal de réseau entre dans la borne de transmission (T) via le premier coupleur (202) sans passer par le premier isolateur (201),
dans laquelle l'impédance de la ligne électrique d'un côté de la borne de transmission (T) n'est pas affectée par un côté de la borne de consommation d'énergie (E) ; le bruit variable dans le temps et l'impédance générés par la borne de consommation d'énergie sont sensiblement isolés au niveau de la borne de consommation d'énergie sans entrer dans la borne de transmission ; et une fréquence de coupure du premier isolateur (201) est inférieure à une fréquence de transmission du signal de réseau, et supérieure à une fréquence de l'onde d'énergie électrique ; et le premier isolateur (201) comprend :
deux transformateurs (K1, K2) respectivement connectés en série à la ligne électrique ; et deux amplificateurs (A1, A2) couplés respectivement à une borne de départ d'une bobine côté primaire et à une borne de départ d'une bobine côté secondaire d'un premier transformateur (K1) des transformateurs (K1, K2), dans laquelle : les bornes de sortie des amplificateurs (A1, A2) sont respectivement couplées entre les bornes d'entrée inverseuses des amplificateurs (A1, A2) et les deux transformateurs (K1, K2) ; et les bornes d'entrée non inverseuses des amplificateurs (A1, A2) sont respectivement couplées à la borne de départ de la bobine côté primaire et à la borne de départ de la bobine côté secondaire du premier transformateur (K1) ; et
plusieurs condensateurs (C) respectivement connectés en parallèle entre la borne de départ de la bobine côté primaire ou la borne de départ de la bobine côté secondaire du premier transformateur (K1), les bornes d'entrée non inverseuses des amplificateurs (A1, A2) et la ligne électrique, et connectés en parallèle entre une borne de fin de la bobine côté primaire du premier transformateur (K1) ou une borne de fin de la bobine côté secondaire du premier transformateur (K1), les bornes d'entrée inverseuses et les bornes de sortie des amplificateurs (A1, A2), et la ligne électrique ; dans laquelle la ligne électrique du côté haute tension est connectée en parallèle à un autre des condensateurs (C).

4. Une structure de circuit pour améliorer la fiabilité d'une communication par ligne électrique, la structure de circuit présentant une ligne électrique sur laquelle une onde d'énergie électrique et un signal de réseau sont transmis, la structure de circuit comprenant :
un premier isolateur (201), qui est disposé à une entrée d'une borne de consommation d'énergie (E) de la structure de circuit, sépare la ligne électrique en la borne de consommation d'énergie (E) et une borne de transmission (T), et filtre le signal de réseau, de sorte que l'onde d'énergie électrique entre dans la borne de consommation d'énergie (E) ; et
un premier coupleur (202) pour générer un premier chemin de couplage, à travers lequel le signal de réseau entre dans la borne de transmission (T) via le premier coupleur (202) sans passer par le premier isolateur (201),
dans laquelle l'impédance de la ligne électrique d'un côté de la borne de transmission (T) n'est pas affectée par un côté de la borne de consommation d'énergie (E) ; le bruit variable dans le temps et l'impédance générés par la borne de consommation d'énergie sont sensiblement isolés au niveau de la borne de consommation d'énergie sans entrer dans la borne de transmission ; et une fréquence de coupure du premier isolateur (201) est inférieure à une fréquence de transmission du signal de réseau, et supérieure à une fréquence de l'onde d'énergie électrique ; et le premier isolateur (201) comprend :
deux transformateurs (K1, K2) respectivement connectés en série à la ligne électrique ; deux amplificateurs (A1, A2) couplés respectivement à une borne de départ d'une bobine côté primaire et à une borne de départ d'une bobine côté secondaire d'un premier transformateur (K1) des transformateurs (K1, K2), dans laquelle les bornes de sortie des amplificateurs (A1, A2) sont respectivement couplées entre les bornes d'entrée inverseuses des amplificateurs (A1, A2) et les deux transformateurs (K1, K2), dans laquelle les bornes d'entrée non inverseuses des amplificateurs (A1, A2) sont respectivement couplées à la borne de départ de la bobine côté primaire et à la borne de départ de la bobine côté secondaire du premier transformateur (K1) des transformateurs (K1, K2) ;
un condensateur (C) connecté en parallèle entre la ligne électrique du côté haute tension, une borne de fin d'une bobine côté primaire et une borne de fin d'une bobine côté secondaire d'un deuxième transformateur (K2) des transformateurs (K1, K2), et la ligne électrique ; et un deuxième coupleur (202a), qui est couplé à la borne de départ et à la borne de fin du premier transformateur (K1), ainsi qu'aux bornes de sortie, aux bornes d'entrée non inverseuses et aux bornes d'entrée inverseuses des amplificateurs (A1, A2), et disposé entre les amplificateurs (A1, A2) et le premier transformateur (K1).

5. Une structure de circuit pour améliorer la fiabilité d'une communication par ligne électrique, la structure de circuit présentant une ligne électrique sur laquelle une onde d'énergie électrique et un signal de réseau sont transmis, la structure de circuit comprenant :
un premier isolateur (201), qui est disposé à une entrée d'une borne de consommation d'énergie (E) de la structure de circuit, sépare la ligne électrique en la borne de consommation d'énergie (E) et une borne de transmission (T), et filtre le signal de réseau, de sorte que l'onde d'énergie électrique entre dans la borne de consommation d'énergie (E) ; et
un premier coupleur (202) pour générer un premier chemin de couplage, à travers lequel le signal de réseau entre dans la borne de transmission (T) via le premier coupleur (202) sans passer par le premier isolateur (201),
dans laquelle l'impédance de la ligne électrique d'un côté de la borne de transmission (T) n'est pas affectée par un côté de la borne de consommation d'énergie (E) ; le bruit variable dans le temps et l'impédance générés par la borne de consommation d'énergie sont sensiblement isolés au niveau de la borne de consommation d'énergie sans entrer dans la borne de transmission ; et une fréquence de coupure du premier isolateur (201) est inférieure à une fréquence de transmission du signal de réseau, et supérieure à une fréquence de l'onde d'énergie électrique ; et le premier isolateur (201) comprend :
deux inductances (L1, L2) connectées en série à un même côté de la ligne électrique ; un amplificateur (A1), dans laquelle une borne d'entrée de l'amplificateur (A1) est couplée à une borne de départ d'une première inductance (L1) des inductances (L1, L2), et une borne de sortie de l'amplificateur (A1) est couplée à une borne d'entrée inverseuse de l'amplificateur (A1) et à une borne de fin de la première inductance (L1) ;
un deuxième coupleur (202a) couplé à une borne d'entrée non inverseuse de l'amplificateur (A1) et à la borne de départ de la première inductance (L1) des inductances (L1, L2), dans laquelle le deuxième coupleur (202a) est couplé à une borne d'entrée inverseuse et à une borne de sortie de l'amplificateur (A1), et à la borne de fin de la première inductance (L1) ; et
un condensateur (C) connecté en parallèle à la ligne électrique.

6. Une structure de circuit pour améliorer la fiabilité d'une communication par ligne électrique, la structure de circuit présentant une ligne électrique sur laquelle une onde d'énergie électrique et un signal de réseau sont transmis, la structure de circuit comprenant :
un premier isolateur (201), qui est disposé à une entrée d'une borne de consommation d'énergie (E) de la structure de circuit, sépare la ligne électrique en la borne de consommation d'énergie (E) et une borne de transmission (T), et filtre le signal de réseau, de sorte que l'onde d'énergie électrique entre dans la borne de consommation d'énergie (E) ; et
un premier coupleur (202) pour générer un premier chemin de couplage, à travers lequel le signal de réseau entre dans la borne de transmission (T) via le premier coupleur (202) sans passer par le premier isolateur (201),
dans laquelle l'impédance de la ligne électrique d'un côté de la borne de transmission (T) n'est pas affectée par un côté de la borne de consommation d'énergie (E) ; le bruit variable dans le temps et l'impédance générés par la borne de consommation d'énergie sont sensiblement isolés au niveau de la borne de consommation d'énergie sans entrer dans la borne de transmission ; et une fréquence de coupure du premier isolateur (201) est inférieure à une fréquence de transmission du signal de réseau, et supérieure à une fréquence de l'onde d'énergie électrique ; et le premier isolateur (201) comprend :
deux transformateurs (K1, K2) respectivement connectés en série à la ligne électrique ; et un amplificateur (A1) ayant une première borne d'entrée non inverseuse (P⁺), une deuxième borne d'entrée non inverseuse (P-), une première borne d'entrée inverseuse (N⁺) et une deuxième borne d'entrée inverseuse, dans laquelle l'amplificateur (A1) est couplé à une borne de départ d'une bobine côté primaire et à une borne de départ d'une bobine côté secondaire d'un premier transformateur (K1) des transformateurs (K1, K2), et une borne de sortie de l'amplificateur (A1) est couplée entre la deuxième borne d'entrée non inverseuse (P⁻) et la deuxième borne d'entrée inverseuse (N⁻) de l'amplificateur (A1), et les deux transformateurs (K1, K2) ;
un condensateur connecté en parallèle entre un deuxième transformateur (K2) des transformateurs (K1, K2) et la ligne électrique ; et deux deuxièmes coupleurs (202a), dans laquelle l'un des deuxièmes coupleurs (202a) est couplé à la borne de départ du premier transformateur (K1) et à la première borne d'entrée non inverseuse (P⁺) ainsi qu'à la première borne d'entrée inverseuse (N⁺) de l'amplificateur (A1), et l'autre des deuxièmes coupleurs (202a) est couplé à une borne de fin du premier transformateur (K1), et à la deuxième borne d'entrée non inverseuse (P⁻), la deuxième borne d'entrée inverseuse (N⁻) et la borne de sortie de l'amplificateur (A1), et est disposé entre l'amplificateur (A1) et le premier transformateur (K1).

7. Une structure de circuit pour améliorer la fiabilité d'une communication par ligne électrique, la structure de circuit présentant une ligne électrique sur laquelle une onde d'énergie électrique et un signal de réseau sont transmis, la structure de circuit comprenant :
un premier isolateur (201), qui est disposé à une entrée d'une borne de consommation d'énergie (E) de la structure de circuit, sépare la ligne électrique en la borne de consommation d'énergie (E) et une borne de transmission (T), et filtre le signal de réseau, de sorte que l'onde d'énergie électrique entre dans la borne de consommation d'énergie (E) ; et
un premier coupleur (202) pour générer un premier chemin de couplage, à travers lequel le signal de réseau entre dans la borne de transmission (T) via le premier coupleur (202) sans passer par le premier isolateur (201),
dans laquelle l'impédance de la ligne électrique d'un côté de la borne de transmission (T) n'est pas affectée par un côté de la borne de consommation d'énergie (E) ; le bruit variable dans le temps et l'impédance générés par la borne de consommation d'énergie sont sensiblement isolés au niveau de la borne de consommation d'énergie sans entrer dans la borne de transmission ; et une fréquence de coupure du premier isolateur (201) est inférieure à une fréquence de transmission du signal de réseau, et supérieure à une fréquence de l'onde d'énergie électrique ; et le premier isolateur (201) comprend :
deux transformateurs (K1, K2) respectivement connectés en série à la ligne électrique ; quatre résistances d'adaptation (Rs), qui servent à l'adaptation d'impédance et sont respectivement couplées entre une borne de départ et une borne de fin du premier transformateur (K1) des transformateurs (K1, K2) ;
un pilote de ligne (LD) ayant des bornes d'entrée couplées à la borne de départ du premier transformateur (K1) et à la résistance d'adaptation (Rs), des bornes de sortie couplées aux deux bornes d'entrée du pilote de ligne (LD) et au premier transformateur (K1), une borne de signal positif de la ligne électrique couplée à une borne de sortie inverse du pilote de ligne (LD), et une borne de signal inverse de la ligne électrique couplée à une borne de sortie positive du pilote de ligne (LD) ;
un condensateur (C) connecté en parallèle à la ligne électrique ; et
deux deuxièmes coupleurs (202a), dans laquelle l'un des deuxièmes coupleurs (202a) est couplé à la borne de départ du premier transformateur (K1) et aux bornes d'entrée du pilote de ligne (LD), et l'autre des deuxièmes coupleurs (202a) est couplé à la borne de fin du premier transformateur (K1) et aux bornes de sortie du pilote de ligne (LD).
